# EUROPEAN PATENT SPECIFICATION

(11) **EP 3 859 757 B1**
(45) Date of publication and mention of the grant of the patent: **30.07.2025**
(21) Application number: 21152173.7
(22) Date of filing: 18.01.2021
(51) Int. Cl.: H01F 1/37, H01F 17/00

(54) **RESIN COMPOSITION**
HARZZUSAMMENSETZUNG
COMPOSITION DE RÉSINE

(30) Priority: 24.01.2020 JP 2020009727
(43) Date of publication of application: 04.08.2021
(73) Proprietor: AJINOMOTO CO., INC., Chuo-ku Tokyo 104-8315 (JP)
(72) Inventor: OOYAMA, Hideki, Kawasaki-shi,, Kanagawa 210-0801 (JP); OURA, Ichiro, Kawasaki-shi,, Kanagawa 210-0801 (JP); TANAKA, Takayuki, Kawasaki-shi,, Kanagawa 210-0801 (JP)
(74) Representative: Mewburn Ellis LLP

(56) References cited:
- EP-A1- 3 771 303
- WO-A1-2013/061478
- WO-A1-2018/194099
- WO-A1-2019/181463
- JP-A- 2019 065 208

## Description

### BACKGROUND OF THE INVENTION

### 1. Field of the Invention

The present invention relates to a resin composition, as well as a magnetic sheet, a circuit substrate, and an inductor substrate, which are obtained by using the resin composition.

### 2. Description of the Related Art

With a recent increase in the demand of reduction in size and thinning of electronic equipment, a circuit substrate to be used in the electronic equipment is also demanded to have a reduced size and an increased wiring density. In the circuit substrate of this type, a through hole is formed. This through hole is sometimes filled with a resin composition including magnetic powder thereby forming a magnetic layer to form an inductor substrate.

For example, in Japanese Patent Application Laid-open No. 2016-197624, a resin composition including a thermosetting resin and magnetic powder such as iron oxide (III) or cobalt ferrite is described as a material to form the magnetic layer inside the through hole in the inductor substrate

WO 2019/181463 A1 discloses a through hole filling paste, comprising: a magnetic powder (A); an epoxy resin (B); and a curing agent (C), wherein the magnetic powder (A) is surface treated with a surface treating agent containing at least one element selected from Si, Al, and Ti.

### SUMMARY OF THE INVENTION

To increase a relative permeability of a cured product of a resin composition including magnetic powder so as to enhance performance of an inductor, a method may be conceived in which the amount of the magnetic powder in the resin composition is increased. The inventor of the present invention increased the amount of ferrite therein as the magnetic powder; however, it was found that not only a viscosity of the resin composition increased but also a mechanical strength and an elongation property of a cured product of the resin composition were deteriorated. The increase in the viscosity of the resin composition can cause deterioration in a handling property and a printing property thereof; and the deterioration in the mechanical strength and the elongation property can cause generation of a crack due to a shear force and so forth.

The present invention was made under the circumstances described above; and thus, an object thereof is to provide: a resin composition that is excellent in a relative permeability of a cured product thereof, low in a viscosity, and excellent in a mechanical strength and an elongation property of the cured product; and a magnetic sheet, a circuit substrate, and an inductor substrate, all being obtained by using this resin composition.

The inventors of the present invention carried out an extensive investigation to solve the problems described above; and as a result, it was found that when a carbon amount included in the ferrite in the resin composition including a thermosetting resin is made to less than a prescribed level, not only the cured product thereof was excellent in its relative permeability, but also the resin composition was low in its viscosity and the cured product thereof was excellent in its mechanical strength and elongation property. The present invention could be completed on the basis of these findings.

Namely, the present invention is defined in the independent claims 1 and 8-11 and optional features are covered by the dependent claims.

The following contents are listed.
[1] A resin composition comprising:
   (A) a ferrite; and
   (B) a thermosetting resin, wherein

   a carbon amount included in the (A) component is 0.1% or less by mass relative to 100% by mass of the (A) component,
   a relative permeability (10 MHz) of a cured product obtained by thermally curing the resin composition at 180°C for 90 minutes is 8 or more, and
   a maximum point strength (23°C) of a cured product obtained by thermally curing the resin composition at 190°C for 90 minutes is 40 MPa or more.
[2] The resin composition according to [1], wherein the (A) component is a spherical ferrite.
[3] The resin composition according to [2], wherein an aspect ratio of the spherical ferrite is 2 or less.
[4] The resin composition according to any one of [1] to [3], wherein the (A) component includes at least one element selected from Ni, Cu, Mn, and Zn.
[5] The resin composition according to any one of [1] to [4], wherein content of the (A) component is 70% or more by mass and 98% or less by mass, on the basis of 100% by mass as non-volatile components in the resin composition.
[6] The resin composition according to any one of [1] to [5], wherein the (B) component comprises an epoxy resin.
[7] The resin composition according to any one of [1] to [6], wherein the resin composition is in a paste-like form.
[8] The resin composition according to any one of [1] to [7], wherein the resin composition is for filling of a through hole.
[9] A magnet sheet comprising:
   a support; and
   a resin composition layer formed on the support, the resin composition layer being formed of the resin composition according to any one of [1] to [8].
[10] A circuit substrate comprising:
   a substrate having a through hole; and
   a cured product of the resin composition according to any one of [1] to 8, the cured product being filled in the through hole.
11. A circuit substrate comprising a magnetic layer that is a cured product of the resin composition according to any one of claims 1 to 8.
12. An inductor substrate comprising the circuit substrate according to claim 10 or 11.

### Advantageous Effects of Invention

According to the present invention, provided are: the resin composition that is excellent in the relative permeability of the cured product thereof, low in the viscosity, and excellent in the mechanical strength and the elongation property of the cured product thereof; and the magnetic sheet, the circuit substrate, and the inductor substrate, all being obtained by using this resin composition.

### BRIEF DESCRIPTION OF THE DRAWINGS

Fig. 1 is a schematic sectional view of the core substrate, as one example of the production method of a circuit substrate according to a first embodiment;
Fig. 2 is a schematic sectional view of the core substrate having a through hole formed therein, as one example of the production method of a circuit substrate according to the first embodiment;
Fig. 3 is a schematic sectional view illustrating the core substrate having a plated layer in a through hole, as one example of the production method of a circuit substrate according to the first embodiment;
Fig. 4 is a schematic sectional view illustrating the core substrate having a magnetic paste filled in a through hole, as one example of the production method of a circuit substrate according to the first embodiment;
Fig. 5 is a schematic sectional view illustrating the core substrate having a filled magnetic paste thermally cured, as one example of the production method of a circuit substrate according to the first embodiment;
Fig. 6 is a schematic sectional view illustrating the core substrate after a cured product is polished, as one example of the production method of a circuit substrate according to the first embodiment;
Fig. 7 is a schematic sectional view illustrating the core substrate having a conductive layer formed on a polished surface, as one example of the production method of a circuit substrate according to the first embodiment;
Fig. 8 is a schematic sectional view illustrating the core substrate having a patterned conductive layer formed, as one example of the production method of a circuit substrate according to the first embodiment;
Fig. 9 is a schematic sectional view to explain the (A) process included in one example of the production method of a circuit substrate according to the second embodiment;
Fig. 10 is a schematic sectional view to explain the (A) process included in one example of the production method of a circuit substrate according to a second embodiment;
Fig. 11 is a schematic sectional view to explain the (B) process included in one example of the production method of a circuit substrate according to the second embodiment;
Fig. 12 is a schematic sectional view to explain the (D) process included in one example of the production method of a circuit substrate according to the second embodiment;
Fig. 13 is a schematic plane view observed from one direction in thickness directions of the inductor substrate that includes the circuit substrate obtained by one example of the production method of a circuit substrate according to the second embodiment;
Fig. 14 is a schematic plane view illustrating a cut end face of the inductor substrate that is obtained as one example of the production method of a circuit substrate according to the second embodiment and that is cut at the place indicated by the II-II one dot chain line; and
Fig. 15 is a schematic plane view to explain a composition of the first conductive layer in the inductor substrate that includes the circuit substrate obtained as one example of the production method of a circuit substrate according to the second embodiment.

### DETAILED DESCRIPTION OF THE PREFERRED EMBODIMENTS

Hereinafter, with referring to the drawings, embodiments of the present invention will be explained. In these drawings, the shape, size, and arrangement of the composition elements are roughly illustrated so as to merely help to understand the present invention. The present invention is limited by the appended claims.

### Resin Composition

The resin composition of the present invention includes (A) a ferrite and (B) a thermosetting resin, in which a carbon amount included in the (A) component is 0.1% or less by mass relative to 100% by mass of the (A) component, a relative permeability (10 MHz) of a cured product obtained by thermally curing the resin composition at 180°C for 90 minutes is 8 or more, and a maximum point strength (23°C) of a cured product obtained by thermally curing the resin composition at 180°C for 90 minutes is 40 MPa or more. In the present invention, when the resin composition is made to include the ferrite whose carbon amount is lower than the prescribed level, the resin composition that is excellent in a relative permeability of the cured product thereof, low in a viscosity, and excellent in a mechanical strength and an elongation property of the cured product can be obtained.

In the resin composition, the (A) component and the (B) component are combined; and in addition, the composition may further include an arbitrary component. Illustrative examples of the arbitrary component include (C) a dispersant, (D) a curing accelerator, and (E) other additives. Hereinafter, each component included in the resin composition of the present invention will be explained in detail.

### (A) Ferrite

The resin composition includes (A) a ferrite as the (A) component. A carbon amount included in the (A) component is 0.1% or less by mass relative to 100% by mass of the (A) component. When the carbon amount included in the (A) component is made to 0.1% or less by mass relative to 100% by mass of the (A) component, the resin composition can have a low viscosity as well as excellent printing and handling properties. In general, the ferrite is produced by mixing a granulated raw material thereof with a sintering adjuvant followed by sintering this mixture. The inventors of the present invention found that the carbon derived from this sintering adjuvant remained in the ferrite even after sintering and that this carbon caused an increase in the viscosity of the resin composition. As far as the inventors of the present invention know, it can be said that the technological idea to lower the viscosity of the resin composition by bringing the carbon amount included in the ferrite to below a prescribed level has not been proposed at all in the past. The carbon amount in a surface modifying agent is not included in the carbon amount mentioned here. The carbon amount included in the (A) component may be controlled, for example, by controlling the amount of the sintering adjuvant such as lauric acid.

The carbon amount included in the (A) component is 0.1% or less by mass, and preferably 0.09% or less by mass, while more preferably 0.08% or less by mass, relative to 100% by mass of the (A) component. The lower limit of the carbon amount is not particularly restricted; it can be 0% or more by mass, 0.001% or more by mass, or the like, relative to 100% by mass of the (A) component.

The carbon amount included in the (A) component may be measured by using a carbon analyzer. In the carbon analyzer, for example, a ferrite to be measured is burnt by a high frequency induction furnace, and then, the carbon amount therein can be obtained by measuring amounts of carbon monoxide and carbon dioxide thus produced by an infrared light absorption method. Specifically, in the carbon analyzer, an oxygen gas pressure is made to 2.5 kg/cm², and a nitrogen gas pressure is made to 2.8 kg/cm². First, the carbon amount in a standard sample whose carbon amount is known and almost in the same level as that of the ferrite to be measured is measured. Next, a blank test is carried out without using the ferrite. Then, a conversion coefficient is calculated by using the following equation. Conversion Coefficient = weight of standard sample (g)/{ (measured value of standard sample) - (measured value of blank test) } x carbon amount in standard sample (% by mass) /100

Next, the ferrite to be measured is measured by using the carbon analyzer, and the carbon amount therein is calculated by using the following equation. Carbon Amount (% by mass) = { (measured value of ferrite to be measured) - (measured value of blank test) } x conversion coefficient/weight of ferrite to be measured (g) x 100

When the (A) component is surface-modified with a surface treating agent to be described later, the ferrite to be measured is heated at 500°C for 6 hours in an electric furnace with flowing nitrogen at the flow rate of 100 mL/minute to remove the surface treating agent on the ferrite surface; and then, the carbon amount is calculated by the method described above. The carbon derived from the sintering adjuvant cannot be removed even about 1, 000°C, but usually the surface treating agent can be completely removed by heating at the temperature of 500°C to 600°C.

Illustrative examples of the ferrite include a Mg-Zn type ferrite, a Fe-Mn type ferrite, a Mn-Zn type ferrite, a Mn-Mg type ferrite, a Cu-Zn type ferrite, a Mg-Mn-Sr type ferrite, a Ni-Zn type ferrite, a Ba-Zn type ferrite, a Ba-Mg type ferrite, a Ba-Ni type ferrite, a Ba-Co type ferrite, a Ba-Ni-Co type ferrite, a Y type ferrite, iron oxide (III) powder, and triiron tetraoxide. Among these, a ferrite including at least one element selected from Ni, Cu, Mn, and Zn is preferable, and the Fe-Mn type ferrite is more preferable. The (A) component may be used singly or as a combination of two or more of these ferrites.

As for the ferrite, a commercially available ferrite may be used. Specific examples of the usable and commercially available ferrite include "M05S" (carbon amount of less than 0.01% by mass) and "E10s" (carbon amount of less than 0.01% by mass), both being manufactured by Powdertech Co., Ltd.

As for the ferrite, a spherical ferrite is preferable. The value that is obtained by dividing a long axis with a short axis of the ferrite (namely, aspect ratio) is preferably 2 or less, more preferably 1.5 or less, still more preferably 1.2 or less, and far still more preferably 1.1 or less, while especially preferably 1.0. In general, the ferrite in a flat shape can have a higher relative permeability than the ferrite in a spherical shape. On the other hand, especially the spherical ferrite can usually have a low magnetic loss; and from a viewpoint to obtain the resin composition having a preferable viscosity, the spherical ferrite is preferably used. The aspect ratio may be measured by the method to be described later.

The average particle diameter of the (A) component may be measured with a laser diffraction/scattering method based on the Mie scattering theory. Specifically, the particle diameter distribution of the magnetic powder on the volume basis is prepared by using a laser diffraction scattering type particle diameter distribution measurement apparatus, and the median diameter thus obtained is taken as the average particle diameter thereof. The measurement sample that is obtained by dispersing the magnetic powders in water by means of an ultrasonic wave is preferably used. Illustrative examples of the laser diffraction and scattering type particle diameter distribution measurement apparatus that can be used include "LA-500" manufactured by Horiba Ltd. and "SALD-7500nano" and "SALD-2200" manufactured by Shimadzu Corp.

The 10% diameter (D10) in a particle diameter distribution is a volume-average particle diameter at the time when a cumulative amount of the volume that is accumulated from the side of a small particle diameter reaches 10% in a particle diameter distribution curve obtained by measurement of the particle diameter distribution with the method described above. The 50% diameter (D50) is a volume-average particle diameter at the time when a cumulative amount of the volume that is accumulated from the side of a small particle diameter reaches 50% in a particle diameter distribution curve obtained by measurement of the particle diameter distribution with the method described above. In addition, the 90% diameter (D90) is a volume-average particle diameter at the time when a cumulative amount of the volume that is accumulated from the side of a small particle diameter reaches 90% in a particle diameter distribution curve obtained by measurement of the particle diameter distribution with the method described above.

From a viewpoint to obtain the cured product that is excellent in the relative permeability, the 10% diameter (D10) in the particle diameter distribution is preferably 0.2 µm or more, and more preferably 0.25 µm or more, while still more preferably 0.3 µm or more. The upper limit thereof is preferably 2.0 µm or less, preferably less than 2.0 µm, and more preferably 1.9 µm or less, while still more preferably 1.8 µm or less.

From a viewpoint to obtain the cured product that is excellent in the relative permeability, the 50% diameter (D50) in the particle diameter distribution is preferably 2.0 µm or more, and more preferably 2.1 µm or more, while still more preferably 2.2 µm or more. The upper limit thereof is preferably 4.3 µm or less, preferably less than 4.3 µm, and more preferably 4.2 µm or less, while still more preferably 4.1 µm or less.

From a viewpoint to obtain the cured product that is excellent in the relative permeability, the 90% diameter (D90) in the particle diameter distribution is preferably 4.3 µm or more, and more preferably 4.4 µm or more, while still more preferably 4.5 µm or more. The upper limit thereof is preferably 8.5 µm or less, and more preferably 8.4 µm or less, while still more preferably 8.3 µm or less.

From a viewpoint to obtain the cured product that is excellent in a magnetic characteristic, a specific surface area of the (A) component is preferably 0.05 m²/g or more, and more preferably 0.1 m²/g or more, while still more preferably 0.3 m²/g or more. Also the specific surface area is preferably 10 m²/g or less, and more preferably 8 m²/g or less, while still more preferably 5 m²/g or less. The specific surface area of the (A) component may be measured by a BET method.

From a viewpoint to enhance the humidity resistance and the dispersion property, the (A) component may be treated with a surface treating agent. Illustrative examples of the surface treating agent include a vinylsilane type coupling agent, a (meth) acryl type coupling agent, a fluorine-containing silane coupling agent, an aminosilane type coupling agent, an epoxy silane type coupling agent, a mercapto silane type coupling agent, a silane type coupling agent, an alkoxy silane, an organosilazane compound, and a titanate type coupling agent. These surface treating agents may be used singly or as an arbitrary combination of two or more of them.

Illustrative examples of the commercially available surface treating agent include "KBM1003" (vinyl triethoxy silane; manufactured by Shin-Etsu Chemical Co., Ld.) ; "KBM503" (3-methacryloxy propyl triethoxy silane; manufactured by Shin-Etsu Chemical Co., Ld.); "KBM403" (3-glycidoxy propyl trimethoxy silane; manufactured by Shin-Etsu Chemical Co., Ld.), "KBM803" (3-mercaptopropyl trimethoxy silane; manufactured by Shin-Etsu Chemical Co., Ld.); "KBE903" (3-aminopropyl triethoxy silane; manufactured by Shin-Etsu Chemical Co., Ld.); "KBM573" (N-phenyl-3-aminopropyl trimethoxy silane; manufactured by Shin-Etsu Chemical Co., Ld.); "SZ-31" (hexamethyl disilazane; manufactured by Shin-Etsu Chemical Co., Ld.); "KBM103" (phenyl trimethoxy silane; manufactured by Shin-Etsu Chemical Co., Ld.); "KBM-4803" (long chain epoxy type silane coupling agent; manufactured by Shin-Etsu Chemical Co., Ld.); and "KBM-7103" (3,3,3-trifluoropropyl trimethoxy silane; manufactured by Shin-Etsu Chemical Co., Ld.).

From a viewpoint to enhance the dispersion property of the (A) component, the degree of the surface treatment by means of the surface treating agent is preferably within a prescribed range. Specifically, the (A) component is surface-treated by the surface treating agent with the amount of preferably 0.2 to 5 parts by mass, preferably 0.2 to 3 parts by mass, and preferably 0.3 to 2 parts by mass, relative to 100 parts by mass of the (A) component.

From a viewpoint to obtain the cured product that is excellent in a magnetic characteristic, the content (% by volume) of the (A) component is, on the basis of 100% by volume as the non-volatile components in the resin composition, preferably 10% or more by volume, and more preferably 20% or more by volume, while still more preferably 30% or more by volume. Also the content is preferably 85% or less by volume, and more preferably 80% or less by volume, while still more preferably 75% or less by volume.

From a viewpoint to obtain the cured product that is excellent in a magnetic characteristic, the content (% by mass) of the (A) component is, on the basis of 100% by mass as the non-volatile components in the resin composition, preferably 70% or more by mass, and more preferably 75% or more by mass, while still more preferably 80% or more by mass. Also the content is preferably 98% or less by mass, and more preferably 95% or less by mass, while still more preferably 90% or less by mass. In the present invention, the content of each component in the resin composition is the value based on 100% by mass as the non-volatile components in the resin composition unless specifically mentioned otherwise.

### (B) Thermosetting Resin

The resin composition includes a thermosetting resin as the (B) component. As for (B) the thermosetting resin, for example, a thermosetting resin that is used at the time when an insulating layer of a wiring board is formed can be used. Illustrative examples of the thermosetting resin like this include an epoxy resin, a phenol type resin, a naphthol type resin, a benzoxazine type resin, an active ester type resin, a cyanate ester type resin, a carbodiimide type resin, an amine type resin, and an acid anhydride type resin. Among these, the resin composition including the epoxy resin is preferable.

(B) These thermosetting resin may be used singly, or as a combination of two or more of those mentioned above. Note that the components capable of curing the resin composition by reacting with an epoxy resin, i.e., the components such as the phenol type resin, the naphthol type resin, the benzoxazine type resin, the active ester type resin, the cyanate ester type resin, the carbodiimide type resin, the amine type resin, and the acid anhydride type resin, are sometimes collectively called "curing agent".

Illustrative examples of the epoxy resin include: a glycyrol type epoxy resin; a bisphenol A type epoxy resin; a bisphenol F type epoxy resin; a bisphenol S type epoxy resin; a bisphenol AF type epoxy resin; a dicyclopentadiene type epoxy resin; a trisphenol type epoxy resin; a phenol novolak type epoxy resin; a tert-butyl-catechol type epoxy resin; epoxy resins having a condensed cyclic structure such as a naphthol novolak type epoxy resin, a naphthalene type epoxy resin, a naphthol type epoxy resin, and an anthracene type epoxy resin; a glycidyl amine type epoxy resin; a glycidyl ester type epoxy resin; a cresol novolak type epoxy resin; a biphenyl type epoxy resin; a linear aliphatic epoxy resin; an epoxy resin having a butadiene structure; an alicyclic epoxy resin; a heterocyclic epoxy resin; an epoxy resin having a spiro ring; a cyclohexane dimethanol type epoxy resin; a trimethylol type epoxy resin; and a tetraphenylethane type epoxy resin. These epoxy resins may be used singly or as a combination of two or more of them. The epoxy resin is preferably one or more epoxy resins selected from the bisphenol A type epoxy resin and the bisphenol F type epoxy resin.

It is preferable that the epoxy resin include an epoxy resin having two or more epoxy groups in one molecule. In addition, the epoxy resin having an aromatic structure is preferable. When two or more of the epoxy resins are used, it is more preferable that at least one of them have an aromatic structure. The aromatic structure means a chemical structure generally defined as aromatic, and this includes a polycyclic aromatic and an aromatic heterocycle. The ratio of the epoxy resin having two or more epoxy groups in one molecule relative to 100% by mass of the non-volatile components in the epoxy resin is preferably 50% or more by mass, and more preferably 60% or more by mass, while especially preferably 70% or more by mass.

As for the epoxy resin, there are an epoxy resin that is in a liquid state at 25°C (hereinafter, this is also called "liquid epoxy resin") and an epoxy resin that is in a solid state at 25°C (hereinafter, this is also called "solid epoxy resin"). When the resin composition includes the epoxy resin as the (B) component, the resin composition may include, as the epoxy resin, only the liquid epoxy resin, or only the solid epoxy resin, or a combination of the liquid epoxy resin and the solid epoxy resin, though from a viewpoint to lower the viscosity of the resin composition, only the liquid epoxy resin is preferably included therein.

The liquid epoxy resin is preferably a glycyrol type epoxy resin, a bisphenol A type epoxy resin, a bisphenol F type epoxy resin, a bisphenol AF type epoxy resin, a naphthalene type epoxy resin, a glycidyl ester type epoxy resin, a glycidyl amine type epoxy resin, a phenol novolak type epoxy resin, an alicyclic epoxy resin having an ester skeleton, a cyclohexane dimethanol type epoxy resin, and an epoxy resin having a butadiene structure. Among these, the glycyrol type epoxy resin, the bisphenol A type epoxy resin, and the bisphenol F type epoxy resin are more preferable. Specific examples of the liquid epoxy resin include: "HP4032", "HP4032D", and "HP4032SS" (all are naphthalene type epoxy resins) manufactured by DIC Corp.; "828US" and "jER828EL" (both are bisphenol A type epoxy resins), "jER807" (a bisphenol F type epoxy resin), and "jER152" (a phenol novolak type epoxy resin), all of these resins being manufactured by Mitsubishi Chemical Corp.; "630" and "630LSD" both being manufactured by Mitsubishi Chemical Corp.; "ED-523T" (a glycyrol type epoxy resin (Adeka glycyrol)), "EP-3980S" (a glycidyl amine type epoxy resin), and "EP-4088S" (a dicyclopentadiene type epoxy resin), all of these resins being manufactured by ADEKA Corp. ; "ZX1059" (a mixture of a bisphenol A type epoxy resin and a bisphenol F type epoxy resin) manufactured by Nippon Steel Chemical & Material Co., Ltd.; "EX-721" (a glycidyl ester type epoxy resin) manufactured by Nagase ChemteX Corp.; "Celloxide-2021P" (an alicyclic epoxy resin having an ester skeleton) and "PB-3600" (an epoxy resin having a butadiene structure), both resins being manufactured by Daicel Corp.; and "ZX1658" and "ZX1658GS" (liquid 1,4-glycidyl cyclohexane) both being manufactured by Nippon Steel Chemical & Material Co., Ltd. These may be used singly or as a combination of two or more of them.

The solid epoxy resin is preferably a naphthalene type 4-functional epoxy resin, a cresol novolak type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, and a tetraphenylethane type epoxy resin. Among them, the naphthalene type 4-functional epoxy resin, the naphthol type epoxy resin, and the biphenyl type epoxy resin are more preferable. Specific examples of the solid epoxy resin include: "HP4032H" (a naphthalene type epoxy resin), "HP-4700" and "HP-4710" (both are naphthalene type four-functional epoxy resins) ; "N-690" (a cresol novolak type epoxy resin), "N-695" (a cresol novolak type epoxy resin), "HP-7200", "HP-7200HH", and "HP-7200H" (all are dicyclopentadiene type epoxy resins), "EXA-7311", "EXA-7311-G3", "EXA-7311-G4", "EXA-7311-G4S", and "HP6000" (all are naphthalene ether type epoxy resins), all of these resins being manufactured by DIC Corp.; "EPPN-502H" (a trisphenol type epoxy resin), "NC7000L" (naphthol novolak type epoxy resin), and "NC3000H", "NC3000", "NC3000L", and "NC3100" (all are biphenyl type epoxy resins), all of these resins being manufactured by Nippon Kayaku Co., Ltd.; "ESN475V" (a naphthalene type epoxy resin) and "ESN485" (a naphthol novolak type epoxy resin), both being manufactured by Nippon Steel Chemical & Material Co., Ltd.; "YX4000H" and "YL6121" (both are biphenyl type epoxy resins), "YX4000HK" (a bixylenol type epoxy resin), and "YX8800" (an anthracene type epoxy resin), all of them being manufactured by Mitsubishi Chemical Corp.; "PG-100" and "CG-500", both being manufactured by Osaka Gas Chemicals Co., Ltd.; and "YL7760" (a bisphenol AF type epoxy resin), "YL7800" (a fluorene type epoxy resin), "jER1010" (a solid bisphenol A type epoxy resin), and "jER1031S" (a tetraphenylethane type epoxy resin), all of them being manufactured by Mitsubishi Chemical Corp. These may be used singly or as a mixture of two or more of them.

When the liquid epoxy resin and the solid epoxy resin are concurrently used as the (B) component, the ratio of them (liquid epoxy resin: solid epoxy resin) is, as the mass ratio, preferably in the range of 1:0.1 to 1:4, and more preferably in the range of 1:0.3 to 1:3.5, while still more preferably in the range of 1:0.6 to 1:3. When the ratio of the liquid epoxy resin and the solid epoxy resin is within this range, the intended advantageous effects of the present invention can be clearly obtained.

The epoxy equivalent of the epoxy resin as the (B) component is preferably in the range of 50 to 5,000 g/eq., more preferably in the range of 50 to 3,000 g/eq., and still more preferably in the range of 80 to 2,000 g/eq., while far still more preferably in the range of 110 to 1,000 g/eq. Within this range, the crosslinking density of a cured product is sufficient, so that a magnetic layer having a low surface roughness can be obtained. The epoxy equivalent, which is a mass of the resin including one equivalent of the epoxy group, can be measured with a method in accordance with JIS K7236.

The weight-average molecular weight of the epoxy resin as the (B) component is preferably in the range of 100 to 5, 000, and more preferably in the range of 250 to 3, 000, while still more preferably in the range of 400 to 1,500. Note that the weight-average molecular weight of the epoxy resin is the weight-average molecular weight in terms of polystyrene measured with a gel permeation chromatography (GPC) method.

As the active ester type resin, resins having one or more active ester groups in one molecule thereof can be used. Among the active ester type resins like this, resins having two or more highly reactive ester groups in one molecule thereof are preferable as the active ester curing agent, these including a phenol ester type, a thiophenol ester type, an N-hydroxyamine ester type, and a heterocyclic hydroxy compound ester type. The active ester type resin is preferably the compound that is obtained by condensation reaction of a carboxylic acid compound and/or a thiocarboxylic acid compound with a hydroxy compound and/or a thiol compound. Especially, in view of enhancement of a heat resistance, an active ester type resin obtained from a carboxylic acid compound and a hydroxy compound is preferable, while an active ester type resin obtained from a carboxylic acid compound and a phenol compound and/or a naphthol compound is more preferable.

Illustrative examples of the carboxylic acid include benzoic acid, acetic acid, succinic acid, maleic acid, itaconic acid, phthalic acid, isophthalic acid, terephthalic acid, and pyromellitic acid.

Illustrative examples of the phenol compound or the naphthol compound include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzene triol, a dicyclopentadiene type diphenol compound, and phenol novolak. Here, "dicyclopentadiene type diphenol compound" means the diphenol compound obtained by condensation of one dicyclopentadiene molecule with two phenol molecules.

Specific examples of the preferable active ester type resin include an active ester type resin containing a dicyclopentadiene type diphenol structure, an active ester type resin containing a naphthalene structure, an active ester type resin containing an acetylated phenol novolak, and an active ester type resin containing a benzoylated phenol novolak. Among them, the active ester type resin containing a naphthalene structure and the active ester type resin containing a dicyclopentadiene type diphenol structure are preferable. Here, "dicyclopentadiene type diphenol structure" means the divalent structure unit formed of phenylene-dicyclopentylene-phenylene.

Illustrative examples of the commercially available active ester type resin include active ester type resins containing a dicyclopentadiene type diphenol structure, such as "EXB9451", "EXB9460", "EXB9460S", "HPC-8000-65T", "HPC-8000H-65TM", and "EXB-8000L-65TM" (all are manufactured by DIC Corp.) ; active ester type resins containing a naphthalene structure, such as "EXB9416-70BK", "EXB-8100L-65T", "EXB-8150L-65T", and "EXB-8150-62T" (all are manufactured by DIC Corp.); active ester type resins containing an acetylated phenol novolak, such as "DC808" (manufactured by Mitsubishi Chemical Corp.); active ester type resins containing a benzoylated phenol novolak, such as "YLH1026" (manufactured by Mitsubishi Chemical Corp.); and active ester type resins as a benzoylated phenol novolak, such as "YLH1026" (manufactured by Mitsubishi Chemical Corp.), "YLH1030" (manufactured by Mitsubishi Chemical Corp.), and "YLH1048" (manufactured by Mitsubishi Chemical Corp.).

In view of the heat resistance and the water resistance, as the phenol type resin and the naphthol type resin, both having a novolak structure are preferable. In view of adhesion with a conductive layer, a nitrogen-containing phenol curing agent is preferable, while a phenol type resin having a triazine skeleton is more preferable.

Specific examples of the phenol type resin and the naphthol type resin include "MEH-7700", "MEH-7810", and "MEH-7851" all being manufactured by Meiwa Plastic Industries, Ltd.; "NHN", "CBN", and "GPH" all being manufactured by Nippon Kayaku Co., Ltd.; "SN170", "SN180", "SN190", "SN475", "SN485", "SN495", "SN-495V", "SN375", and "SN395" all being manufactured by Nippon Steel Chemical & Material Co., Ltd.; and "TD-2090", "LA-7052", "LA-7054", "LA-1356", "LA-3018-50P", and "EXB-9500" all being manufactured by DIC Corp.

Specific examples of the benzoxazine type resin include "JBZ-OD100" (benzoxazine ring equivalent of 218 g/eq.), "JBZ-OP100D" (benzoxazine ring equivalent of 218 g/eq.), and "ODA-BOZ" (benzoxazine ring equivalent of 218 g/eq.) all being manufactured by JFE Chemical Corp.; "P-d" (benzoxazine ring equivalent of 217 g/eq.) and "F-a" (benzoxazine ring equivalent of 217 g/eq.), both being manufactured by Shikoku Chemicals Corp.; and "HFB2006M" (benzoxazine ring equivalent of 432 g/eq.) manufactured by Showa Highpolymer Co., Ltd.

Illustrative examples of the cyanate ester type resin include bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene) )benzene, bis(4-cyanatephenyl) thioether, and bis(4-cyanatephenyl) ether; polyfunctional cyanate resins derived from a phenol novolak, a cresol novolak, and the like; and a prepolymer in which these cyanate resins are partially made to triazine. Specific examples of the cyanate ester type resin include "PT30" and "PT60" (both are phenol novolak type polyfunctional cyanate ester resins); "ULL-950S" (polyfunctional cyanate ester); "BA230" and "BA230S75" (prepolymers in which part or all of bisphenol A dicyanate is made to triazine so as to be a trimer), all of these being manufactured by Lonza Japan Ltd.

Specific examples of the carbodiimide type resin include Carbodilite (registered trade mark) V-03 (carbodiimide equivalent of 216 g/eq.), V-05 (carbodiimide equivalent of 262 g/eq.), V-07 (carbodiimide equivalent of 200 g/eq.), and V-09 (carbodiimide equivalent of 200 g/eq.) all being manufactured by Nisshinbo Chemical, Inc.; and Stabaxol (registered trade mark) P (carbodiimide equivalent of 302 g/eq.) manufactured by Rhein Chemie GmbH.

The amine type resin can be the resin having one or more amino groups in one molecule thereof. Illustrative examples thereof include an aliphatic amine, a polyether amine, an alicyclic amine, and an aromatic amine. Among them, in view of expressing the intended effects of the present invention, an aromatic amine is preferable. The amine type resin is preferably a primary amine and a secondary amine, while a primary amine is more preferable. Specific examples of the amine curing agent include 4,4'-methylene bis(2,6-dimethylaniline), diphenyl diaminosulfone, 4,4'-diaminodiphenylmethane, 4,4'-diaminodiphenyl sulfone, 3,3'-diaminodiphenyl sulfone, m-phenylene diamine, m-xylylene diamine, diethyltoluene diamine, 4,4'-diaminodiphenyl ether, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3-dimethyl-5,5-diethyl-4,4-diphenylmethane diamine, 2,2-bis(4-aminophenyl)propane, 2,2-bis(4-(4-aminophenoxy)phenyl)propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, bis(4-(4-aminophenoxy)phenyl) sulfone, and bis(4-(3-aminophenoxy)phenyl) sulfone. Commercially available amine type resins may be used. Illustrative examples thereof include "KAYABOND C-200S", "KAYABOND C-100", "KAYAHARD A-A", "KAYAHARD A-B", and "KAYAHARD A-S" all being manufactured by Nippon Kayaku Co. Ltd., as well as "Epicure W" manufactured by Mitsubishi Chemical Corp.

The acid anhydride type resin may be those having one or more acid anhydride groups in one molecule thereof. Specific examples of the acid anhydride type resin include phthalic anhydride, tetrahydrophthalic anhydride, hexahydrophthalic anhydride, methyl tetrahydrophthalic anhydride, methyl hexahydrophthalic anhydride, methylnadic anhydride, hydrogenated methylnadic anhydride, trialkyl tetrahydrophthalic anhydride, dodecenyl succinic anhydride, 5-(2,5-dioxotetrahydro-3-furanyl)-3-methyl-3-cyclohexene-1, 2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphto[1,2-C]furan-1,3-dione, ethylene glycol bis(anhydrotrimellitate), and a polymer type acid anhydride such as a styrene-maleic acid resin, which is a copolymer of styrene and maleic acid.

When the epoxy resin and a curing agent are included in the (B) component, the ratio of the epoxy resin to all the curing agents, in terms of the ratio of [total number of the epoxy groups in the epoxy resin] to [total number of the reactive groups in the curing agent], is preferably in the range of 1:0.01 to 1:5, and more preferably in the range of 1:0.5 to 1:3, while still more preferably in the range of 1:1 to 1:2. Note that, "the number of the epoxy groups in the epoxy resin" means the total value of the values obtained by dividing the mass of the non-volatile components of the epoxy resin that is present in the resin composition with the epoxy equivalent. "The number of the reactive groups in the curing agent" means the total value of the values obtained by dividing the mass of the non-volatile components of the curing agent that is present in the resin composition with the equivalent of the reactive group.

From a viewpoint to obtain the cured product having excellent mechanical and magnetic characteristics, the content of (B) the thermosetting resin is, on the basis of 100% by mass as the non-volatile components in the resin composition, preferably 1% or more by mass, and more preferably 5% or more by mass, while still more preferably 10% or more by mass. Although the upper limit thereof is not particularly restricted so far as the advantageous effects of the present invention can be expressed, the upper limit is preferably 30% or less by mass, and more preferably 25% or less by mass, while still more preferably 20% or less by mass.

In (B) the thermosetting resin, the content of the solid thermosetting resin is, on the basis of 100% by mass as (B) the thermosetting resin in the resin composition, preferably 25% or less by mass, and more preferably 20% or less by mass, while still more preferably 15% or less by mass, 10% or less by mass, or 8% or less by mass, and preferably 0.1% or more by mass, and more preferably 0.5% or more by mass, while still more preferably 1% or more by mass. "The solid thermosetting resin" means a thermosetting resin that is in a solid state in which the viscosity thereof at 25°C is 20 Pa·s or more. When the content of the solid thermosetting resin is controlled within this range, the viscosity of the resin composition can be lowered.

### (C) Dispersant

The resin composition may further include (C) a dispersant as the arbitrary component.

Illustrative examples of (C) the dispersant include: phosphate ester type dispersants such as a polyoxyethylene alkyl ether phosphate; anion type dispersants such as sodium dodecylbenzene sulfonate, sodium laurate, and an ammonium polyoxyethylene alkyl ether sulfate; and nonionic dispersants such as an organosiloxane type dispersant, a polyoxyalkylene type dispersant, an acetylene glycol, a polyoxyethylene alkyl ether, a polyoxyethylene alkyl ester, a polyoxyethylene sorbitan fatty acid ester, a polyoxyethylene alkyl phenyl ether, a polyoxyethylene alkylamine, and a polyoxyethylene alkylamide. Among these, the nonionic dispersants are preferable. (C) The dispersant may be used singly, or as a mixture of two or more of those mentioned above.

As for the phosphate ester type dispersant, a commercially available dispersant may be used. Illustrative examples of the commercially available phosphate ester type dispersant include "RS-410", "RS-610", and "RS-710" of the "Phosphanol" series manufactured by Toho Chemical Industry Co., Ltd.

As for the organosiloxane type dispersant, illustrative examples of this type that is commercially available include "BYK 347" and "BYK 348" manufactured by BYK Chemie GmbH.

As for the polyoxyalkylene type dispersant, illustrative examples of this type that is commercially available include "AKM-0531", "AFB-1521", "SC-0505K", "SC-1015F", "SC-0708A", and "HKM-50A" of the "Mariarim" series manufactured by NOF Corp. The polyoxyalkylene type dispersant is the general term of the polyoxyethylene alkyl ether, the polyoxyethylene alkyl ester, the polyoxyethylene sorbitan fatty acid ester, the polyoxyethylene alkyl phenyl ether, the polyoxyethylene alkylamine, the polyoxyethylene alkylamide, and the like.

As for the acetylene glycol, illustrative examples of this type that is commercially available include "82", "104", "440", "465", "485", and "Olefin Y" of the "Surfynol" series manufactured by Air Products and Chemicals Inc.

When the resin composition includes (C) the dispersant, from a viewpoint to clearly express the advantageous effects of the present invention, the content of (C) the dispersant is, on the basis of 100% by mass as the non-volatile components in the resin composition, preferably 0.1% or more by mass, and more preferably 0.3% or more by mass, while still more preferably 0.5% or more by mass. The upper limit thereof is preferably 5% or less by mass, and more preferably 3% or less by mass, while still more preferably 1% or less by mass.

### (D) Curing Accelerator

The resin composition can further include, as an arbitrary component, (D) a curing accelerator. Illustrative examples of (D) the curing accelerator include a phosphorous type curing accelerator, an amine type curing accelerator, an imidazole type curing accelerator, a guanidine type curing accelerator, and a metal type curing accelerator. Among these, the phosphorous type curing accelerator, the amine type curing accelerator, the imidazole type curing accelerator, and the metal type curing accelerator are preferable. The amine type curing accelerator, the imidazole type curing accelerator, and the metal type curing accelerator are more preferable, while the imidazole type curing accelerator is still more preferable. (D) The curing accelerator may be used singly, or as a combination of two or more of those mentioned above.

Illustrative examples of the phosphorous type curing accelerator include triphenyl phosphine, a phosphonium borate compound, tetraphenyl phosphonium tetraphenyl borate, n-butyl phosphonium tetraphenyl borate, a tetrabutyl phosphonium decanoate salt, (4-methylphenyl) triphenyl phosphonium thiocyanate, tetraphenyl phosphonium thiocyanate, and butyl triphenyl phosphonium thiocyanate. Among these, triphenyl phosphine and a tetrabutyl phosphonium decanoate salt are preferable.

Illustrative examples of the amine type curing accelerator include: trialkyl amines such as triethyl amine and tributyl amine; and 4-dimethylaminopyridine, benzyl dimethyl amine, 2,4,6-tris(dimethylaminomethyl)phenol, and 1,8-diazabicyclo(5,4,0)-undecene. Among these, 4-dimethylaminopyridine and 1,8-diazabicyclo(5,4,0)-undecene are preferable.

Illustrative examples of the imidazole type curing accelerator include imidazole compounds such as 2-methyl imidazole, 2-undecyl imidazole, 2-heptadecyl imidazole, 1,2-dimethyl imidazole, 2-ethyl-4-methyl imidazole, 1,2-dimethyl imidazole, 2-ethyl-4-methyl imidazole, 2-phenyl imidazole, 2-phenyl-4-methyl imidazole, 1-bezyl-2-methyl imidazole, 1-benzyl-2-phenyl imidazole, 1-cyanoethyl-2-methyl imidazole, 1-cyanoethyl-2-undecyl imidazole, 1-cyanoethyl-2-ethyl-4-methyl imidazole, 1-cyanoethyl-2-phenyl imidazole, 1-cyanoethyl-2-undecyl imidazolium trimellitate, 1-cyanoethyl-2-phenyl imidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-metylimidazolyl-(1')]-ethyl-s-tr iazine, 2,4-diamino-6-[2'-methylimidazolyl-(1')]-ethyl-s-triazine isocyanuric acid adduct, 2-phenylimidazole isocyanuric acid adduct, 2-phenyl-4,5-dihydroxymethyl imidazole, 2-phenyl-4-methyl-5-hydroxymethyl imidazole, 2,3-dihydro-1H-pyrro[1,2-a]benzimidazole, 1-dodecyl-2-methyl-3-benzyl imidazolium chloride, 2-methyl imidazoline, and 2-phenyl imidazoline; and adducts of these imidazole compounds with an epoxy resin. Among these, 2-ethyl-4-methyl imidazole and 1-benzyl-2-phenyl imidazole are preferable.

As for the imidazole type curing accelerator, commercially available products thereof may be used. Illustrative examples thereof include "2P4MZ" manufactured by Shikoku Chemicals Corp. and "P200-H50" manufactured by Mitsubishi Chemical Corp.

Illustrative examples of the guanidine type curing accelerator include dicyan diamide, 1-methyl guanidine, 1-ethyl guanidine, 1-cyclohexyl guanidine, 1-phenyl guanidine, 1-(o-tolyl) guanidine, dimethyl guanidine, diphenyl guanidine, trimethyl guanidine, tetramethyl guanidine, pentamethyl guanidine, 1,5,7-triazabicyclo[4.4.0]deca-5-ene, 7-methyl-1,5,7-triazabicyclo[4.4.0]deca-5-ene, 1-methyl biguanide, 1-ethyl biguanide, 1-n-butyl biguanide, 1-n-octadecyl biguanide, 1,1-dimethyl biguanide, 1,1-diethyl biguanide, 1-cyclohexyl biguanide, 1-allyl biguanide, 1-phenyl biguanide, and 1-(o-tolyl) biguanide. Among these, dicyan diamide and 1,5,7-triazabicyclo[4.4.0]deca-5-ene are preferable.

Illustrative examples of the metal type curing accelerator include organometallic complexes or organometallic salts of metals such as cobalt, copper, zinc, iron, nickel, manganese, and tin. Specific examples of the organometallic complex include organic cobalt complexes such as cobalt (II) acetylacetonate and cobalt (III) acetylacetonate; organic copper complexes such as copper (II) acetylacetonate; organic zinc complexes such as zinc (II) acetylacetonate; organic iron complexes such as iron (III) acetylacetonate; organic nickel complexes such as nickel (II) acetylacetonate; and organic manganese complexes such as manganese (II) acetylacetonate. Illustrative examples of the organometallic salt include zinc octylate, tin octylate, zinc naphthenate, cobalt naphthenate, tin stearate, and zinc stearate.

When the resin composition includes (D) the curing accelerator, from a viewpoint to obtain the cured product having further enhanced mechanical characteristics, the content of (D) the curing accelerator is, on the basis of 100% by mass as the non-volatile components in the resin composition, preferably 0.1% or more by mass, and more preferably 0.3% or more by mass, while still more preferably 0.5% or more by mass, and preferably 5% or less by mass, and more preferably 3% or less by mass, while still more preferably 1% or less by mass.

### (E) Arbitrary Additive

The resin composition of the present invention may further include an arbitrary additive as necessary. Illustrative examples of the other additive like this include thermoplastic resins such as a phenoxy resin, a flame retardant, organometallic compounds such as an organic copper compound, an organic zinc compound, and an organic cobalt compound, as well as resin additives such as a thickener, an antifoaming agent, a leveling agent, an adhesion assisting agent, and a colorant.

### Production Method of the Resin Composition

The resin composition may be produced, for example, with a method in which blended components are agitated by using an agitator such as three rollers and a rotation mixer.

### Physical Properties and the Like of the Resin Composition

The resin composition has the characteristic of a low viscosity. Accordingly, the resin composition can have a characteristic that the resin composition is in a paste-like form (paste-like resin composition). Thus, the resin composition can be suitably used as a filling material of a through hole. Specifically, the viscosity of the resin composition at 25°C is preferably 200 Pa·s or less, and more preferably 150 Pa·s or less, while still more preferably 140 Pa·s or less. Although there is no particular restriction with regard to the lower limit thereof, the lower limit is preferably 20 Pa·s or more, while more preferably 30 Pa·s or more. The viscosity may be measured by using an E-type viscometer while keeping the temperature of the resin composition at 25±2°C. Specifically, the viscosity may be measured by the method described in Examples to be described later.

Usually, the resin composition can be in a paste-like form, which is the characteristic that the resin composition has a low viscosity even without including a solvent. Therefore, the content of the solvent in the resin composition is preferably 1.0% or less by mass, more preferably 0.8% or less by mass, and still more preferably 0.5% or less by mass, while especially preferably 0.1% or less by mass, relative to the total mass of the resin composition. Although the lower limit thereof is not particularly restricted, the lower limit is preferably 0.001% or more by mass, or preferably the solvent is not included therein. When a liquid thermosetting resin or the like is used, usually, the viscosity of the resin composition can be lowered even when the solvent is not included therein. When the amount of the solvent in the resin composition is small, not only generation of a void due to evaporation of the solvent can be suppressed, but also application to a vacuum printing becomes possible.

The cured product obtained by thermally curing the resin composition at 180°C for 90 minutes has a characteristic that the relative permeability thereof at the frequency of 10 MHz is high. The relative permeability at the frequency of 10 MHz is 8 or more, and preferably 9 or more, while more preferably 10 or more. Although The upper limit thereof is not particularly restricted, it can be 50 or less, or the like. The relative permeability may be measured by the method described in Examples to be described later.

It is preferable that the cured product obtained by thermally curing the resin composition at 180°C for 90 minutes be high in the relative permeability at the frequency of 100 MHz. The relative permeability at the frequency of 100 MHz is preferably 5 or more, and more preferably 6 or more, while still more preferably 7 or more. Although the upper limit thereof is not particularly restricted, it can be 30 or less, or the like. The relative permeability may be measured by the method described in Examples to be described later.

The cured product obtained by thermally curing the resin composition at 180°C for 90 minutes has a characteristic that the magnetic loss thereof at the frequency of 10 MHz is low. The magnetic loss at the frequency of 10 MHz is preferably 0.3 or less, and more preferably 0.2 or less, while still more preferably 0.1 or less. Although the upper limit thereof is not particularly restricted, it can be 0.001 or more, or the like. The magnetic loss may be measured by the method described in Examples to be described later.

It is preferable that the cured product obtained by thermally curing the resin composition at 180°C for 90 minutes be low in the magnetic loss at the frequency of 100 MHz. The magnetic loss at the frequency of 100 MHz is preferably 0.3 or less, and more preferably 0.2 or less, while still more preferably 0.1 or less. Although the lower limit thereof is not particularly restricted, it can be 0.001 or more, or the like. The magnetic loss may be measured by the method described in Examples to be described later.

The cured product obtained by thermally curing the resin composition at 190°C for 90 minutes has a characteristic that the maximum point strength thereof is high. The maximum point strength at 23°C is 40 MPa or more, and preferably 50 MPa or more, while more preferably 55 MPa or more. Although the upper limit thereof is not particularly restricted, it can be 200 MPa or less, or the like. The maximum point strength may be measured by the method described in Examples to be described later.

It is preferable that the cured product obtained by thermally curing the resin composition at 190°C for 90 minutes be high in elongation thereof. The elongation at 23°C is preferably 0.4% or more, and more preferably 0.5% or more, while still more preferably 0.6% or more. Although the upper limit thereof is not particularly restricted, it can be 5% or less, or the like. The elongation may be measured by the method described in Examples to be described later.

### Magnetic Sheet

The magnetic sheet includes a support and a resin composition layer formed on the support, the resin composition layer being formed of the resin composition of the present invention.

In view of thinning, thickness of the resin composition layer is preferably 250 µm or less, and more preferably 200 µm or less. Although the lower limit of the thickness of the resin composition layer is not particularly restricted, it can be usually 5 µm or more, 10 µm or more, or the like.

Illustrative examples of the support include a film formed of a plastic material, metal foil, and a releasing paper. Among them, a film formed of a plastic material and metal foil are preferable.

When the film formed of a plastic material is used as the support, illustrative examples of the plastic material include polyesters such as polyethylene terephthalate (hereinafter, sometimes this is simply called "PET") and polyethylene naphthalate (hereinafter, sometimes this is simply called "PEN"); polycarbonate (hereinafter, sometimes this is simply called "PC") ; acrylic polymers such as polymethyl methacrylate (PMMA); a cyclic polyolefin; triacetyl cellulose (TAC) ; polyether sulfide (PES); polyether ketone; and polyimide. Among them, polyethylene terephthalate and polyethylene naphthalate are preferable, while cheap polyethylene terephthalate is especially preferable.

When the metal foil is used as the support, illustrative examples of the metal foil include copper foil and aluminum foil, while copper foil is preferable. As to the copper foil, the foil formed of a copper single metal or an alloy of copper with other metal (for example, tin, chromium, silver, magnesium, nickel, zirconium, silicon, and titanium) may be used.

The support may be subjected to a treatment such as a mat treatment, or a corona treatment on the surface to be bonded with the resin composition layer.

As for the support, a releasing layer-attached support having a releasing layer on the surface to be bonded to the resin composition layer may be used. The releasing agent used in the releasing layer of the releasing layer-attached support may be one or more releasing agents selected from the group consisting of, for example, an alkyd resin, a polyolefin resin, a urethane resin, and a silicone resin. Commercially available products may be used as the releasing layer-attached support, such as for example, a PET film having a releasing layer formed of the alkyd resin type releasing agent as a main ingredient. Illustrative examples thereof include "PET501010", "SK-1", "AL-5", and "AL-7" all being manufactured by Lintech Corp.; "Lumirror T60" manufactured by Toray Industries; "Purex" manufactured by Teijin Ltd.; and "Unipeel" manufactured by Unitika Ltd.

Although thickness of the support is not particularly restricted, this is preferably in the range of 5 to 75 µm, while more preferably in the range of 10 to 60 µm. When the releasing layer-attached support is used, total thickness of the releasing layer-attached support is preferably within this range.

In the magnet sheet, a protection film similar to the support may be further laminated on the surface of the resin composition layer not bonded to the support (namely, on the surface opposite to the support). Although thickness of the protection film is not particularly restricted, for example, this is in the range of 1 to 40 µm. By laminating the protection film, the surface of the resin composition layer may be prevented from attachment of dirt and the like as well as from a scar. The magnetic sheet can be rolled up so as to be stored. When the magnetic sheet has the protection film, the magnetic sheet can be used by removing the protection film.

### Circuit Substrate and Production Method thereof

The circuit substrate according to a first embodiment includes a substrate having a through hole and a cured product of the resin composition of the present invention that is filled in the through hole. The circuit substrate according to a second embodiment includes a magnetic layer of the magnetic sheet formed of a cured product of the resin composition layer. Hereinafter, the first embodiment and the second embodiment with regard to the production method of the circuit substrate will be explained. Note that the production method of the circuit substrate relating to the present invention is not limited to the first embodiment or the second embodiment exemplified below.

### First Embodiment

The circuit substrate according to the first embodiment is produced, for example, by the production method including following processes (1) to (4). In the first embodiment, it is preferable to form the magnetic layer by using the resin composition, and it is more preferable to form the magnetic layer by using the resin composition in a paste-like form.
(1) A process at which the resin composition is filled in a through hole of the substrate having the through hole;
(2) a process at which the resin composition is thermally cured to obtain a cured product;
(3) a process at which a surface of the cured product or of the resin composition is polished; and
(4) a process at which a conductive layer is formed on a polished surface of the cured product.

The production method of the circuit substrate according to the present invention may be carried out in the order of the processes (1) to (4), or the process (2) may be carried out after the process (3).

Hereinafter, the processes (1) to (4) upon producing the circuit substrate will be explained in detail.

### Process (1)

Upon carrying out the process (1), the process may include a preparation process of the resin composition. The resin composition has already been explained above.

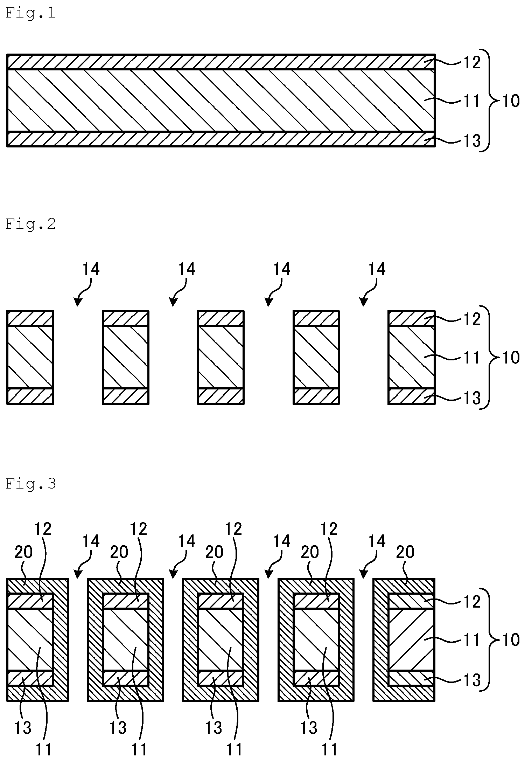

Upon carrying out the process (1), as illustrated in Fig. 1 as one example, the process may include a process to prepare a core substrate 10 having a supporting substrate 11, and a first metal layer 12 and a second metal layer 13 that are formed of a metal such as copper foil on both surfaces of the supporting substrate 11. Illustrative examples of the material of the supporting substrate 11 include an insulating substrate such as a glass epoxy substrate, a metal substrate, a polyester substrate, a polyimide substrate, a BT resin substrate, and a thermosetting type polyphenylene ether substrate. Illustrative examples of the material of the first and the second metal layers include carrier-attached copper foil and a material of the conductive layer to be described later.

In addition, as illustrated in Fig. 2 as one example, the process may include a process to form a through hole 14 in the core substrate 10. The through hole 14 may be formed, for example, by a drill, a laser irradiation, or a plasma irradiation. Specifically, the through hole 14 may be formed by forming a penetrating hole in the core substrate 10 by using a drill or the like.

Formation of the through hole 14 may be carried out by using a drilling machine that is commercially available. Illustrative examples of the commercially available drilling machine include "ND-1S211" manufactured by Hitachi Via Mechanics, Ltd.

After the through hole 14 is formed in the core substrate 10, as illustrated in Fig. 3 as one example, the process may include a process to carry out a roughening treatment to the core substrate 10 followed by formation of a plated layer 20 in the through hole 14, on the surface of the first metal layer 12, and on the surface of the second metal layer 13.

The roughening treatment may be carried out with any of a dry roughening treatment and a wet roughening treatment. Illustrative examples of the dry roughening treatment include a plasma treatment. Illustrative examples of the wet roughening treatment include a method in which a swelling treatment by a swelling liquid, a roughening treatment by an oxidant, and a neutralizing treatment by a neutralizing solution are carried out in this order.

The plated layer 20 is formed by a plating method. The procedure to form the plated layer 20 by the plating method is the same as that in formation of a conductive layer at the process (4) to be described later.

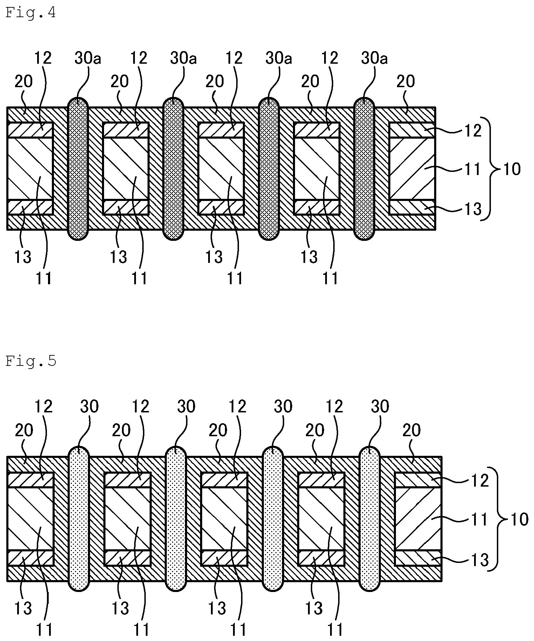

After the core substrate 10 having the plated layer 20 formed in the through hole 14 is prepared, as illustrated in Fig. 4 as one example, a resin composition 30a is filled into the through hole 14. The filling may be carried out, for example, by a printing method. Illustrative examples of the printing method include a method in which the resin composition 30a is printed to the through hole 14 via a squeegee, a method in which the resin composition 30a is printed via a cartridge, a method in which the resin composition 30a is printed by a mask printing, a roll coating method, and an inkjet method.

### Process (2)

After the resin composition 30a is filled into the through hole 14, at the process (2), the resin composition 30a is thermally cured to form a cured product layer (magnetic layer) 30 in the through hole 14, as illustrated in Fig. 5 as one example. The thermal curing condition of the resin composition 30a is different depending on the composition and kind of the resin composition 30a. The curing temperature is preferably 120°C or higher, and more preferably 130°C or higher, while still more preferably 150°C or higher, and preferably 240°C or lower, and more preferably 220°C or lower, while still more preferably 200°C or lower. The curing time of the resin composition 30a is preferably 5 minutes or longer, and more preferably 10 minutes or longer, while still more preferably 15 minutes or longer, and preferably 120 minutes or shorter, and more preferably 100 minutes or shorter, while still more preferably 90 minutes or shorter.

The curing degree of the magnetic layer 30 at the process (2) is preferably 80% or more, and more preferably 85% or more, while still more preferably 90% or more. The curing degree may be measured, for example, by using a differential scanning calorimeter.

Before the resin composition 30a is thermally cured, the resin composition 30a may be subjected to a preliminary heat treatment by heating at the temperature lower than the curing temperature. For example, prior to the thermal curing of the resin composition 30a, the resin composition 30a may be preliminary heated usually in the temperature range of 50°C or higher to lower than 120°C (preferably in the range of 60°C or higher and 110°C or lower, while more preferably in the range of 70°C or higher and 100°C or lower), and for the period of usually 5 minutes or longer (preferably in the range of 5 to 150 minutes, while more preferably in the range of 15 to 120 minutes) .

### Process (3)

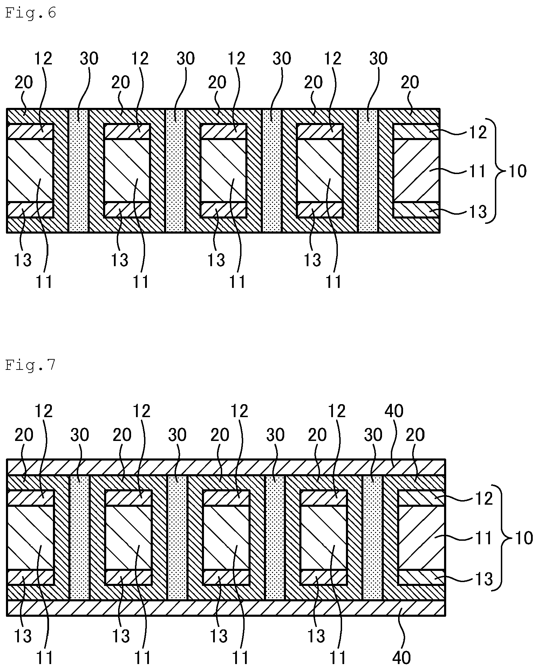

At the process (3), as illustrated in Fig. 6 as one example, an excess amount of the magnetic layer 30 that is projected from or attached to the core substrate 10 is removed by polishing to flatten the surface thereof. The polishing method that can polish the excess amount of the magnetic layer 30 that is projected from or attached to the core substrate 10 may be used. Illustrative examples of the polishing method like this include a buff polishing method and a belt polishing method. Illustrative examples of the buff polishing equipment that is commercially available include "NT-700IM" manufactured by Ishii hyoki Co., Ltd.

From a viewpoint to enhance the plating adhesion, the arithmetic average roughness (Ra) of the polished surface of the magnetic layer is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) may be measured, for example, by using a non-contact type surface roughness meter.

When the process (3) is carried out after the process (2), among other purposes, with a purpose to further increase the curing degree of the magnetic layer, a heat treatment may be carried out, as needed, after the process (2) and before the process (3). The temperature at the heating process may be similar to the curing temperature described before. Therefore, the temperature is preferably 120°C or higher, and more preferably 130°C or higher, while still more preferably 150°C or higher, and preferably 240°C or lower, and more preferably 220°C or lower, while still more preferably 200°C or lower. The time for the heat treatment is preferably 5 minutes or longer, and more preferably 10 minutes or longer, while still more preferably 15 minutes or longer, and preferably 90 minutes or shorter, and more preferably 70 minutes or shorter, while still more preferably 60 minutes or shorter.

When the process (3) is carried out before the process (2), a preliminary heat treatment may be carried out before the process (3) by heating at the temperature lower than the curing temperature of the resin composition. The temperature at the preliminary heat treatment is preferably 100°C or higher, and more preferably 110°C or higher, while still more preferably 120°C or higher, and preferably 240°C or lower, and more preferably 220°C or lower, while still more preferably 200°C or lower. The time for the heat treatment is preferably 5 minutes or longer, and more preferably 10 minutes or longer, while still more preferably 15 minutes or longer, and preferably 90 minutes or shorter, and more preferably 70 minutes or shorter, while still more preferably 60 minutes or shorter.

### Process (4)

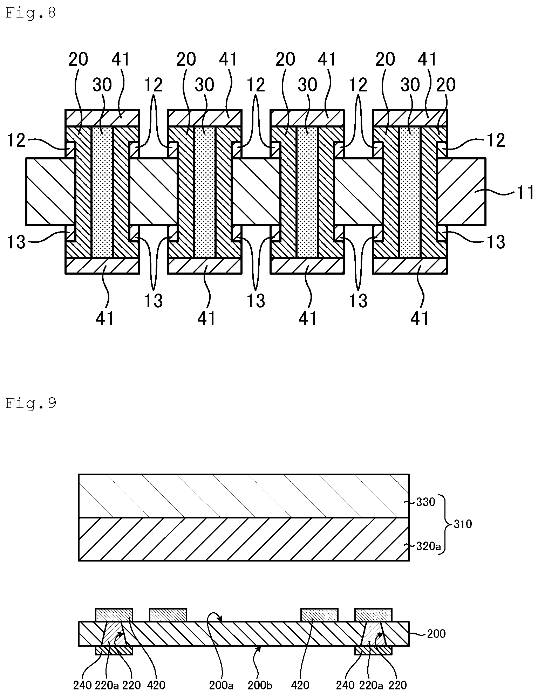

At the process (4), as illustrated in Fig. 7 as one example, a conductive layer 40 is formed on the polished surface of the magnetic layer 30 and on the plated layer 20. Then, after the conductive layer 40 is formed, as illustrated in Fig. 8 as one example, by carrying out a treatment such as etching, a patterned conductive layer 41 may be formed by removing part of the conductive layer 40, the first metal layer 12, the second metal layer 13, and the plated layer 20. In the example illustrated here, because the cured product has already been polished at the process (3), a process of a roughening treatment of the magnetic layer is not included. In Fig. 7, the conductive layer 40 is formed on both surfaces of the core substrate 10, but the conductive layer 40 may be formed on only one surface of the core substrate 10.

Illustrative examples of the method for forming the conductive layer include a plating method, a sputtering method, and a vacuum evaporation method. Among them, the plating method is preferable. In the preferable embodiment, the surface of the cured product is plated with an appropriate method such as a semi-additive method or a full additive method to form the patterned conductive layer having an intended wiring pattern. Illustrative examples of the material of the conductive layer include: a single metal such as gold, platinum, palladium, silver, copper, aluminum, cobalt, chromium, zinc, nickel, titanium, tungsten, iron, tin, and indium; and metal alloys of two or more metals selected from the group consisting of gold, platinum, palladium, silver, copper, aluminum, cobalt, chromium, zinc, nickel, titanium, tungsten, iron, tin, and indium. Among these, from viewpoints of general applicability, cost, easiness in patterning, and the like, preferable to be used are chromium, nickel, titanium, aluminum, zinc, gold, palladium, silver, and copper, as well as a nickel-chromium alloy, a copper-nickel alloy, and a copper-titanium alloy. More preferable to be used are chromium, nickel, titanium, aluminum, zinc, gold, palladium, silver, and copper, as well as a nickel-chromium alloy. Copper is still more preferable.

Here, an example of the embodiment to form the patterned conductive layer on the polished surface of the cured product will be explained in detail. A plated seed layer is formed on the polished surface of the cured product by electroless plating. Next, onto the plated seed layer thus formed, an electroplated layer is formed by electroplating; and as needed, an unnecessary plated seed layer is removed by a treatment such as etching, whereby the conductive layer having an intended wiring pattern can be formed. After the conductive layer is formed, among other purposes, with a purpose to enhance the peel strength of the conductive layer, an annealing treatment may be carried out, as necessary. The annealing treatment may be carried out, for example, by heating the circuit substrate in the temperature range of 150 to 200°C for the period of 20 to 90 minutes.

From a viewpoint of thinning, the thickness of the patterned conductive layer is preferably 70 µm or less, more preferably 60 µm or less, still more preferably 50 µm or less, and far still more preferably 40 µm or less, while especially preferably 30 µm or less, 20 µm or less, 15 µm or less, or 10 µm or less. The lower limit thereof is preferably 1 µm or more, and more preferably 3 µm or more, while still more preferably 5 µm or more.

### Second Embodiment

The circuit substrate according to the second embodiment includes a magnetic layer formed of a cured product of the resin composition. In the second embodiment, it is preferable to form the magnetic layer by using a magnetic sheet. Hereinafter, the second embodiment with regard to the production method of a product substrate will be explained. Explanation overlapped with the first embodiment will be omitted as appropriate.

The circuit substrate of the second embodiment is produced, for example, by the production method including the following processes (A) to (D):
(A) a process at which a magnetic sheet is laminated to an inner substrate such that a resin composition layer be bonded to the inner substrate to form a magnetic layer;
(B) a process at which a hole-making process to form a hole in the magnetic layer is carried out;
(C) a process at which a surface of the magnetic layer is polished: and
(D) a process at which a conductive layer is formed on a polished surface of the magnetic layer.

Hereinafter, upon producing the circuit substrate, the processes (A) to (D) will be explained in detail.

### Process (A)

The process (A) is the process at which a magnetic sheet is laminated to an inner substrate such that a resin composition layer may be bonded to the inner substrate to form a magnetic layer. In one embodiment of the process (A), the magnetic sheet is laminated to the inner substrate such that the resin composition layer may be bonded to the inner substrate, and then, the resin composition layer is thermally cured to form the magnetic layer.

At the process (A), as illustrated in Fig. 9 as one example, a magnetic sheet 310 having a support 330 and a resin composition layer 320a formed on the support 330 is laminated to an inner substrate 200 such that the resin composition layer 320a may be bonded to the inner substrate 200.

The inner substrate 200 is an insulating substrate. Illustrative examples of the material of the inner substrate 200 include insulating substrates such as a glass epoxy substrate, a metal substrate, a polyester substrate, a polyimide substrate, a BT resin substrate, and a thermosetting type polyphenylene ether substrate. The inner substrate 200 may be an inner layer circuit substrate having a wiring or the like incorporated in the thickness thereof.

As illustrated in Fig. 9 as one example, the inner substrate 200 has a first conductive layer 420 formed on a first main surface 200a and an outside terminal 240 formed on a second main surface 200b. The first conductive layer 420 may include a plurality of wirings. In the example illustrated by the drawing, only a wiring that constitutes a coil-like conductive structural body 400 of an inductor element is illustrated. The outside terminal 240 is a terminal to electrically connect to an outside device or the like that is not illustrated in the drawing. The outside terminal 240 may be constructed as part of a conductive layer formed on the second main surface 200b.

Conductive materials that are capable of constructing the first conductive layer 420 and the outside terminal 240 are the same as the materials of the conductive layer that have been explained in the paragraphs of "Process (4)" of the first embodiment.

The first conductive layer 420 and the outside terminal 240 may be any of a monolayer structure and a multilayer structure in which two or more layers formed of single metal layers formed of different metals or of alloy layers are laminated. Thicknesses of the first conductive layer 420 and of the outside terminal 240 are the same as those of a second conductive layer 440 to be described later.

The line (L)/space (S) ratios of the first conductive layer 420 and of the outside terminal 240 are not particularly restricted. From a viewpoint to reduce irregularity of the surface thereby obtaining the magnetic layer that is excellent in the smoothness, the ratio is usually 900/900 µm or less, preferably 700/700 µm or less, more preferably 500/500 µm or less, and still more preferably 300/300 µm or less, while far still more preferably 200/200 µm or less. Although the lower limit of the line/space ratio is not particularly restricted, from a viewpoint to enhance an embedding property of the resin composition layer into the space, the ratio is preferably 1/1 µm or more.

The inner substrate 200 may have a plurality of through holes 220 such that these may penetrate the inner substrate 200 from the first main surface 200a to the second main surface 200b. In the through hole 220, an inside-the-through-hole wiring 220a is formed. The inside-the-through-hole wiring 220a electrically connects the first conductive layer 420 with the outside terminal 240.

Bonding of the resin composition layer 320a to the inner layer substrate 200 may be carried out, for example, by hot-press bonding of the magnet sheet 310 to the inner layer substrate 200 from the side of the support 330. Illustrative examples of the component for hot-press bonding of the magnetic sheet 310 to the inner layer substrate 200 (hereinafter, this component is also called "hot-pressing component") include a heated metal plate (stainless steel (SUS) mirror plate or the like) and a heated metal roll (SUS roll). At this time, it is preferable that the hot-pressing component be not pressed directly to the magnetic sheet 310 but pressed via a sheet or the like formed of an elastic material such as a heat-resistant rubber so that the magnetic sheet 310 may well follow the surface irregularity of the inner layer substrate 200.

The temperature at the time of the hot-press bonding is preferably in the range of 80°C to 160°C, and more preferably in the range of 90°C to 140°C, while still more preferably in the range of 100°C to 120°C. The pressure at the time of the hot-press bonding is preferably in the range of 0.098 to 1.77 MPa, while more preferably in the range of 0.29 to 1.47 MPa. The period at the time of the hot-press bonding is preferably in the range of 20 to 400 seconds, while more preferably in the range of 30 to 300 seconds. The bonding of the magnetic sheet to the inner substrate is carried out preferably under an evacuated condition with the pressure of 26.7 hPa or less.

Bonding of the resin composition layer 320a of the magnetic sheet 310 to the inner layer substrate 200 may be carried out by using a commercially available vacuum laminator. Illustrative examples of the commercially available vacuum laminator include a vacuum and pressure laminator manufactured by Meiki Co., Ltd. and a vacuum applicator manufactured by Nikko-Materials Co., Ltd.

After bonding of the resin sheet 310 to the inner layer substrate 200, under a normal pressure (under an atmospheric pressure), for example, the laminated magnetic sheet 310 may be flattened by pressing the hot-pressing component from the side of the support thereof. The pressing conditions of the flattening process can be the same as the hot-press bonding conditions in the before-mentioned lamination. The flattening process may be carried out by using a commercially available laminator. Note that the lamination and the flattening processes may be carried out continuously by using the commercially available vacuum laminator described above.

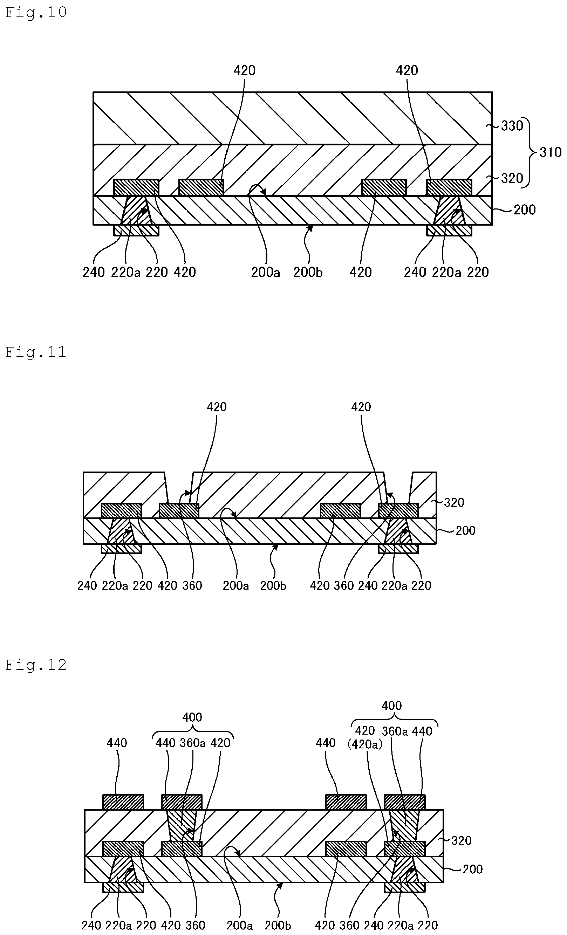

After the magnetic sheet is laminated to the inner substrate, the resin composition layer is thermally cured to form a magnetic layer. As illustrated in Fig. 10 as one example, the resin composition layer 320a that is bonded to the inner substrate 200 is thermally cured to form a first magnetic layer 320.

Conditions of the thermal curing of the resin composition layer 320a are different depending on the composition and kind of the resin composition. The curing temperature is preferably 120°C or higher, and more preferably 130°C or higher, while still more preferably 150°C or higher, and preferably 240°C or lower, and more preferably 220°C or lower, while still more preferably 200°C or lower. The curing period of the resin composition layer 320a is preferably 5 minutes or longer, and more preferably 10 minutes or longer, while still more preferably 15 minutes or longer, and preferably 120 minutes or shorter, and more preferably 100 minutes or shorter, while still more preferably 90 minutes or shorter.

The support 330 may be removed between after thermal curing at the (A) process and the (B) process, or after the (B) process.

### (B) Process

At the (B) process, as illustrated in Fig. 11 as one example, a via hole 360 is formed by carrying out the hole-making process in the first magnetic layer 320. The via hole 360 will be a channel to electrically connect the first magnetic layer 420 with the second conductive layer 440 to be described later. Formation of the via hole 360 may be carried out by using a drill, a laser, a plasma, or the like in accordance with composition and the like of the resin composition used to form the magnetic layer. The size and shape of the hole may be arbitrarily determined in accordance with a design of the printed wiring board.

### (C) Process

At the (C) process, the surface of the magnetic layer formed with the via hole is polished. Polishing at the (C) process may be carried out with the same polishing method as the method already explained in the paragraphs of "Process (3)" in the first embodiment.

From a viewpoint to enhance the plating adhesion, the arithmetic average roughness (Ra) of the polished surface of the magnetic layer is preferably 300 nm or more, and more preferably 350 nm or more, while still more preferably 400 nm or more. The upper limit thereof is preferably 1,000 nm or less, and more preferably 900 nm or less, while still more preferably 800 nm or less. The surface roughness (Ra) may be measured, for example, by using a non-contact type surface roughness meter.

### (D) Process

At the (D) process, as illustrated in Fig. 12 as one example, the second conductive layer 440 is formed on the first magnetic layer 320.

The conductive materials that are capable of constituting the second conductive layer 440 are the same as those of the conductive layer explained in the paragraphs of "Process (4)" in the first embodiment.

From a viewpoint of thinning, the thickness of the second conductive layer 440 is preferably 70 µm or less, more preferably 60 µm or less, still more preferably 50 µm or less, and far still more preferably 40 µm or less, while especially preferably 30 µm or less, 20 µm or less, 15 µm or less, or 10 µm or less. The lower limit thereof is preferably 1 µm or more, and more preferably 3 µm or more, while still more preferably 5 µm or more.

The second conductive layer 440 may be formed by plating. For example, the second conductive layer 440 is preferably formed by a wet plating method such as a semi-additive method including an electroless plating process, a mask patterning process, an electroplating process, and a flash etching process, as well as a full additive method. When the second conductive layer 440 is formed by the wet plating method, the second conductive layer 440 having an intended wiring pattern can be formed. Note that, at this process, an inside-the-via-hole wiring 360a is concurrently formed in the via hole 360.

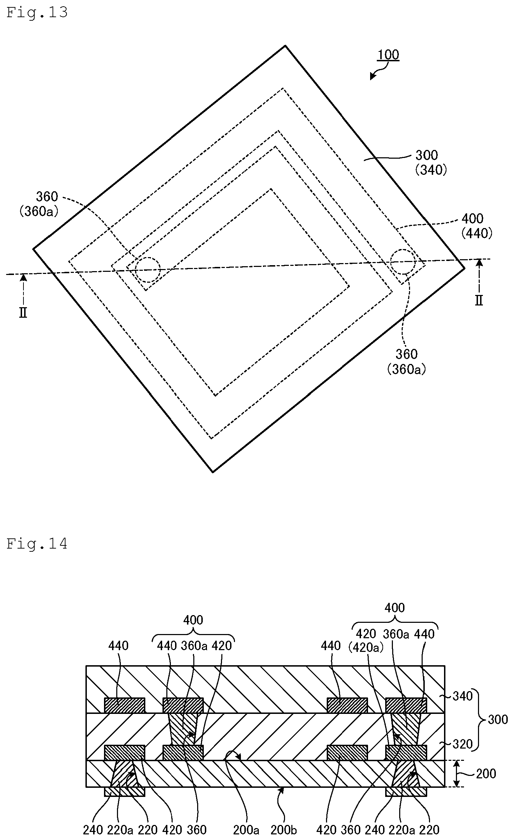

The first conductive layer 420 and the second conductive layer 440 may be formed, for example, spirally, as illustrated in Fig. 13 to Fig. 15 to be described later as one example. In one example, one end in the center side of the spiral wiring of the second conductive layer 440 is electrically connected through the inside-the-via-hole wiring 360a to one end in the center side of the spiral wiring of the first conductive layer 420. Other end in the circumferential side of the spiral wiring of the second conductive layer 440 is electrically connected through the inside-the-via-hole wiring 360a to a land 420a of the first conductive layer 420. Therefore, the other end in the circumferential side of the spiral wiring of the second conductive layer 440 is electrically connected to the outside terminal 240 through the inside-the-via-hole wiring 360a, the land 420a, and the inside-the-through-hole wiring 220a.

The coil-like conductive structural body 400 is composed of the spiral wiring that is part of the first conductive layer 420, the spiral wiring that is part of the second conductive layer 440, and the inside-the-via-hole wiring 360a that electrically connects between the spiral wiring of the first conductive layer 420 and the spiral wiring of the second conductive layer 440.

After the (D) process, a process to further form a magnetic layer on the conductive layer may be carried out. Specifically, as illustrated in Fig. 14 as one example, a second magnetic layer 340 is formed on the first magnetic layer 320 that has the second conductive layer 440 and the inside-the-via-hole wiring 360a formed therein. The second magnetic layer may be formed with the same process as the process that has already been explained.

### Inductor Substrate

The inductor substrate includes the circuit substrate of the present invention. When the inductor substrate includes the circuit substrate obtained by the production method of the circuit substrate according to the first embodiment, the inductor substrate has an inductor pattern that is formed by a conductor at least in part around the cured product of the resin composition. The inductor substrate like this may be, for example, the one that is described in Japanese Patent Application Laid-open No. 2016-197624.

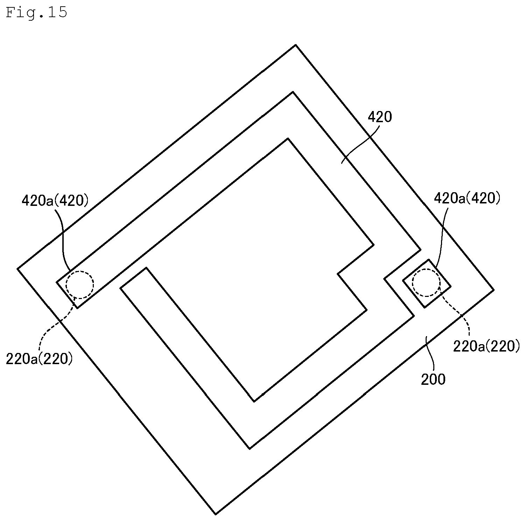

When the inductor substrate includes the circuit substrate obtained by the production method of the circuit substrate according to the second embodiment, the inductor substrate has a magnetic layer and a conductive structural body having at least part thereof been embedded into the magnetic layer. The inductor substrate includes this conductive structural body and an inductor element that is extendedly present in a thickness direction of the magnetic layer and is composed of part of the magnetic layer surrounded with the conductive structural body. Note that, Fig. 13 is a schematic plane view from one direction in a thickness direction of the inductor substrate, which includes the inductor element therein. Fig. 14 is a schematic plane view illustrating a cut end face of the inductor substrate that is cut at the place indicated by the II-II one dot chain line illustrated in Fig. 13. Fig. 15 is a schematic plane view to explain a composition of the first conductive layer in the inductor substrate.

As illustrated in Fig. 13 and Fig. 14 as one example, a inductor substrate 100 has a plurality of the magnetic layers (the first magnetic layer 320 and the second magnetic layer 340) and a plurality of the conductive layers (the first conductive layer 420 and the second conductive layer 440). Namely, this is a build-up wiring board having a build-up magnetic layer and a build-up conductive layer. Also, the inductor substrate 100 has an inner substrate 200.

From Fig. 14, the first magnetic layer 320 and the second magnetic layer 340 constitute a magnetic member 300, which can be regarded as an integrated magnetic layer of these magnetic layers. Therefore, the coil-like conductive structural body 400 is formed such that at least part thereof may be embedded into the magnetic member 300. Namely, in the inductor substrate 100 according to this embodiment, the inductor element is composed of the coil-like conductive structural body 400 and a core part, which is extendedly present in the thickness direction of the magnetic member 300 and is part of the magnetic member 300 that is surrounded with the coil-like conductive structural body 400.

As illustrated in Fig. 15 as one example, the first conductive layer 420 includes the spiral wiring to constitute the coil-like conductive structure 400 and the land 420a in a square shape that is electrically connected to the inside-the-through-hole wiring 220a. In the example illustrated by the drawing, the spiral wiring includes a linear portion, a bent portion that is bent at a right angle to the linear portion, and a detour portion that detours the land 420a. In the example illustrated by the drawing, outline of the entire spiral wiring of the first conductive layer 420 is substantially in a square shape and has a shape that the wiring is whirled in the anticlockwise direction from a center side to an outer side.

Similarly, the second conductive layer 440 is formed on the first magnetic layer 320. The second conductive layer 440 includes the spiral wiring to constitute the coil-like conductive structural body 400. In Fig. 13 or Fig. 14, the spiral wiring includes a linear portion and a bent portion that is bent at a right angle to the linear portion. In Fig. 13 or Fig. 14, outline of the entire spiral wiring of the second conductive layer 440 is substantially in a square shape and has a shape that the wiring is whirled clockwise from a center side to an outer side.

The inductor substrate can be used as the wiring board to mount an electronic part such as a semiconductor chip, and can also be used as a (multi-layered) printed wiring board that uses this wiring board as the inner substrate. In addition, this can be used as a chip inductor substrate obtained by dicing the wiring board, and can also be used as a printed wiring board that is surface-mounted with the chip inductor substrate.

In addition, by using this wiring board, semiconductor devices with various embodiments may be produced. The semiconductor device having the wiring board can be suitably used in electric products (for example, a computer, a mobile phone, a digital camera, and a television), vehicles (for example, a motor bike, an automobile, a train, a marine ship, and an airplane), and so forth.

### EXAMPLES

Hereinafter, the present invention will be specifically explained, but the present invention is not limited to these Examples. Note that, in the description below, "part" and "%" that describe quantity mean "part by mass" and "% by mass", respectively, unless otherwise specifically mentioned.

### Example 1

Iron oxide and manganese oxide were weighed such that the mole ratio of iron to manganese might be 8:1; then, water was added to these, and then they were mixed and crushed to prepare the slurry with a solid concentration of 50% by mass. The crushed average particle diameter (primary particle diameter of raw material) at this moment was 5 µm. The slurry thus prepared was granulated by means of a spray dryer, and then the granules were classified to obtain the granules having an average particle diameter of about 50 µm. Then, 5 parts by mass of lauric acid in a powder form was mixed with 100 parts by mass of the granules thus obtained to obtain a raw material for thermal spraying.

Next, the raw material for thermal spraying thus obtained was supplied into a flammable gas flare (propane/oxygen=1/7) in the thermal spraying equipment to carry out thermal spraying (ferrite formation). Subsequently, with supplying an air, this was transported by an air stream while being rapidly cooled. The ferrite thus formed was collected by means of the air stream classification equipment (cyclone) that was installed in the downstream side of the thermal spray equipment. Then, this ferrite was classified so as to give an intended particle diameter distribution to obtain the spherical ferrite particle A (aspect ratio of 1.0).

A mixture of 100 parts by mass of the ferrite particle A, 15 parts by mass of an epoxy resin ("ZX-1059"; a mixture of bisphenol A type epoxy resin and bisphenol F type epoxy resin; manufactured by Nippon Steel & Sumikin Materials Co., Ltd.), 1 part by mass of a curing facilitator ("2P4MZ"; imidazole type curing facilitator; manufactured by Shikoku Chemicals Corp.), and 1 part by mass of a dispersant ("SC-1015F"; polyoxyalkylene type dispersant; manufactured by NOF Corp.) was uniformly dispersed by using a high-speed rotation mixer to obtain the resin composition 1 in a paste-like form.

### Example 2

In Example 1, the amount of lauric acid was changed from 5 parts by mass to 3 parts by mass. The spherical ferrite particle B was prepared with the same manner as Example 1 except for the above-mentioned change; and then, the resin composition 2 in a paste-like form was obtained. The aspect ratio of the spherical ferrite particle B was 1.0.

### Example 3

In Example 1, the amount of lauric acid was changed from 5 parts by mass to 1.5 parts by mass. The spherical ferrite particle C was prepared with the same manner as Example 1 except for the above-mentioned change; and then, the resin composition 3 in a paste-like form was obtained. The aspect ratio of the spherical ferrite particle C was 1.0.

### Example 4

In Example 1, lauric acid was not used. The spherical ferrite particle D was prepared with the same manner as Example 1 except for the above-mentioned change; and then, the resin composition 4 in a paste-like form was obtained. The aspect ratio of the spherical ferrite particle D was 1.0.

### Example 5

In Example 4, the ferrite particle D was surface-modified with a silane coupling agent by the method described below to obtain the spherical ferrite particle E. The ferrite particle E was prepared with the same manner as Example 4 except for the above-mentioned change; and then, the resin composition 5 in a paste-like form was obtained.

The ferrite particle D (100 parts by mass) was treated with 0.5 part by mass of a silane coupling agent ("KBM-403"; manufactured by Shin-Etsu Silicon Co., Ltd.) to obtain the ferrite particle E. The aspect ratio of the spherical ferrite particle E was 1.0.

### Example 6

In Example 4, the amount of the spherical ferrite particle D was changed from 100 parts by mass to 150 parts by mass. The resin composition 6 in a paste-like form was prepared with the same manner as Example 4 except for the above-mentioned change.

### Comparative Example 1

In Example 1, the amount of lauric acid was changed from 5 parts by mass to 15 parts by mass. The ferrite particle F was prepared with the same manner as Example 1 except for the above-mentioned change; and then, the resin composition 6 in a paste-like form was obtained. The aspect ratio of the spherical ferrite particle F was 1.0.

### Measurement of Aspect Ratio of Ferrite Particle

The ferrite particle was measured with a scanning electron microscope (SEM), and the lengths of the image were measured by using image analysis software. The SEM pictures of each particle were obtained with the condition of 10 kV and with the magnification of 1,000. The value dividing the maximum diameter length with the width that is perpendicular to the maximum diameter length was taken as the aspect ratio. The aspect ratio of the particle was the average value of 30 particles.

### Measurement of Particle Diameter Distribution of Ferrite Particles

Ferrite particles (0.05 g) and 20 mL of water were taken into a 30-mL beaker, and then, 0.01 g of sodium hexamethaphosphate as the dispersant was added to it. Next, this mixture was dispersed by using an ultrasonic homogenizer (UH-150 type; manufactured by SMT Co., Ltd.). The dispersion was carried out for 20 seconds with setting the ultrasonic homogenizer at the output level of 4. Then, after the foam formed on the surface of the beaker was removed, the dispersion solution was introduced into a laser diffraction type particle diameter distribution analyzer (SALD-7500nano; manufactured by Shimadzu Corp.) for measurement. From this measurement, the 10% diameter (D10), the 50% diameter (D50), and the 90% diameter (D90) in the volume-based particle diameter distribution were obtained. At this time, the pump speed of 7, the built-in ultrasonic wave irradiation time of 30 seconds, and the refractive index of 1.70-050i were used as the measurement conditions.

### Measurement of Carbon Amount in Surface-unmodified Ferrite Particle

The carbon amount in the ferrite particles A to D and F were measured by using a carbon analyzer (C-200; manufactured by LECO Corp.) with the oxygen gas pressure of 2.5 kg/cm² and the nitrogen gas pressure of 2.8 kg/cm². First, the standard sample whose carbon amount is known and almost in the same level as that of the ferrite particle was measured with this analyzer. In addition, the measurement was carried out without using the sample itself (blank test). Then, the conversion coefficient was calculated from the measured values by using the following equation. Conversion Coefficient = weight of standard sample (g)/{(measured value of standard sample) - (measured value of blank test) } x carbon amount in standard sample (% by mass) /100

Next, the ferrite particle was measured by using the carbon analyzer, and the carbon amount therein was calculated by using the following equation. Carbon Amount (% by mass) = { (measured value of ferrite particle) - (measured value of blank test)} x conversion coefficient/weight of ferrite particle (g) x 100

### Measurement of Carbon Amount in Surface-modified Ferrite Particle

The ferrite particle E (2 g) was heated at 500°C for 6 hours in an electric furnace ("FP 102"; manufactured by Yamato-net Co., Ltd.) with flowing nitrogen at the flow rate of 100 mL/minute to remove the silane coupling agent on the surface of the ferrite particle. After the silane coupling agent was removed, the carbon amount therein was measured by the same method as that of the ferrite particle whose surface was not treated.

The particle diameter distributions and the carbon amounts in the ferrite particles A to F measured by the respective methods described above are summarized in Table below.

**Table 1**

| (Table 1) | | | | |
|---|---|---|---|---|
| | Carbon amount | D10 (*µ* m) | D50 (*µ* m) | D90 (*µ* m) |
| Ferrite particle A | 0.08% by mass | 2.0 | 4.1 | 9.5 |
| Ferrite particle B | 0.06% by mass | 1.8 | 3.6 | 9.9 |
| Ferrite particle C | 0.03% by mass | 1.8 | 3.8 | 8.5 |
| Ferrite particle D | Less than 0.01% by mass | 1.7 | 3.4 | 8.2 |
| Ferrite particle E | Less than 0.01% by mass | 1.7 | 3.4 | 9.0 |
| Ferrite particle F | 0.20% by mass | 1.8 | 3.8 | 10.9 |

### Measurement of Viscosity

With keeping the temperature of the resin composition of each of Examples and Comparative Example at 25±2°C, the viscosity thereof was measured by using an E-type viscometer ("RE-80U"; 3° x R9.7 rotor; manufactured by Toki Sangyo Co., Ltd.) with the measurement sample volume of 0.22 mL and the rotation number of 5 rpm as the measurement conditions.

### Measurement of Relative Permeability

A polyethylene terephthalate (PET) film that was treated with a silicone type releasing agent ("PET 501010"; thickness of 50 µm; manufactured by Lintec Corp.) was prepared as a support. Each of the resin compositions 1 to 6 was uniformly applied onto the release-treated surface of the PET film by using a doctor blade such that the thickness of the resin composition layer after dried might become 100 µm to obtain a magnetic sheet. The magnetic sheet thus obtained was heated at 180°C for 90 minutes to thermally cure the resin composition layer; and then, the support was removed to obtain a cured product in a sheet form. The cured product in the sheet form thus obtained was cut to a specimen having the width of 5 mm and the length of 18 mm; and this was used as a sample for evaluation. The relative permeability (µ') and the magnetic loss (tanδ (=µ"/µ')) of the sample for evaluation thus obtained were measured at room temperature (23°C) with the 3-turn coil method and the measurement frequency of 10 MHz by using Agilent Technologies ("HP 8362B"; manufactured by Agilent Technologies, Inc.). By using the same method with the measurement frequency of 100 MHz, the relative permeability (µ') and the magnetic loss (tanδ ) were measured at room temperature (23°C).

### Measurements of the Maximum Point Strength and Elongation

A polyethylene terephthalate (PET) film that was treated with a silicone type releasing agent ("PET 501010"; thickness of 50 µm; manufactured by Lintec Corp.) was prepared as a support. Each of the resin compositions 1 to 6 was uniformly applied onto the release-treated surface of the PET film by using a doctor blade such that the thickness of the resin composition layer after dried might become 100 µm to obtain a magnetic sheet. The magnetic sheet thus obtained was heated at 190°C for 90 minutes to thermally cure the resin composition layer; and then, the support was removed to obtain a cured product in a sheet form. The cured product in the sheet form thus obtained was subjected to the tensile test in accordance with Japanese Industrial Standard (JIS K7127) by using Tensilon Universal Testing Machine (manufactured by A&D Co., Ltd.) to obtain the maximum point strength and the elongation at 23°C.

**Table 2**

| (Table 2) | | | | | | | | |
|---|---|---|---|---|---|---|---|---|
| | | Example | | | | | | Comparative Example |
| | | 1 | 2 | 3 | 4 | 5 | 6 | 1 |
| (A) Component | Ferrite particle A | 100 | | | | | | |
| | Ferrite particle B | | 100 | | | | | |
| | Ferrite particle C | | | 100 | | | | |
| | Ferrite particle D | | | | 100 | | 150 | |
| | Ferrite particle E | | | | | 100 | | |
| Ferrite | Ferrite particle F | | | | | | | 100 |
| (B) Component | ZX-1059 | 15 | 15 | 15 | 15 | 15 | 15 | 15 |
| (C) Component | SC-1015F | 1 | 1 | 1 | 1 | 1 | 1 | 1 |
| (D) Component | 2P4MZ | 1 | 1 | 1 | 1 | 1 | 1 | 1 |
| Evaluation | Viscosity (25°C. 5 rpm) | 135 | 130 | 135 | 135 | 120 | 200 | 390 |
| | Relative permeability (100 MHz) | 8.4 | 8.6 | 8.7 | 9.1 | 9.1 | 11.1 | 7.5 |
| | Magnetic loss (100 MHz) | 0.08 | 0.09 | 0.08 | 0.09 | 0.08 | 0.12 | 0.08 |
| | Relative permeability (10 MHz) | 8.5 | 8.7 | 8.8 | 9.1 | 9.2 | 11.3 | 7.6 |
| | Magnetic loss (10 MHz) | 0.08 | 0.09 | 0.08 | 0.09 | 0.08 | 0.11 | 0.08 |
| | Maximum point strength (MPa) | 60 | 60 | 60 | 55 | 55 | 50 | 25 |
| | Elongation (%) | 0.7 | 0.7 | 0.7 | 0.7 | 0.7 | 0.7 | 0.3 |

As can be seen in Table, in Examples 1 to 6, not only the relative permeability is excellent but also the viscosity can be lowered; in addition, it can be seen that these have higher relative permeabilities and lower viscosities than Comparative Example 1. It can also be seen that Examples 1 to 5 are superior in the maximum point strength and the elongation to those of Comparative Example 1.

## Claims

1. A resin composition comprising:
(A) a ferrite; and
(B) a thermosetting resin,
wherein the content of the (A) component is 70% or more by mass and 98% or less by mass, on the basis of 100% by mass as nonvolatile components in the resin composition, and
the content of the (B) component is 1% or more by mass and 30% or less by mass, on the basis of 100% by mass as nonvolatile components in the resin composition, and wherein the resin is
**characterized in that**:
a carbon amount included in the (A) component is 0.1% or less by mass relative to 100% by mass of the (A) component, wherein
the carbon amount included in the (A) component is measured using a carbon analyzer; in the carbon analyzer, a ferrite to be measured is burnt by a high frequency induction furnace, and then, the carbon amount therein can be obtained by measuring amounts of carbon monoxide and carbon dioxide thus produced by an infrared light absorption method; in the carbon analyzer, an oxygen gas pressure is made to 2.5 kg/cm², and a nitrogen gas pressure is made to 2.8 kg/cm²; first, the carbon amount in a standard sample whose carbon amount is known and almost in the same level as that of the ferrite to be measured is measured; next, a blank test is carried out without using the ferrite; then, a conversion coefficient is calculated; next, the ferrite to be measured is measured by using the carbon analyzer, and the carbon amount therein is calculated; when the (A) component is surface-modified with a surface treating agent, the ferrite to be measured is heated at 500°C for 6 hours in an electric furnace with flowing nitrogen at the flow rate of 100 mL/minute to remove the surface treating agent on the ferrite surface prior to measurement of the carbon amount,
a relative permeability (10 MHz) of a cured product obtainable by thermally curing the resin composition at 180°C for 90 minutes is 8 or more, and
a maximum point strength (23°C) of a cured product obtainable by thermally curing the resin composition at 190°C for 90 minutes is 40 MPa or more.

2. The resin composition according to claim 1, wherein the (A) component is a spherical ferrite.

3. The resin composition according to claim 2, wherein an aspect ratio of the spherical ferrite is 2 or less.

4. The resin composition according to any one of claims 1 to 3, wherein the (A) component includes at least one element selected from Ni, Cu, Mn, and Zn.

5. The resin composition according to any one of claims 1 to 4, wherein the (B) component comprises an epoxy resin.

6. The resin composition according to any one of claims 1 to 5, wherein the resin composition is in a paste-like form.

7. The resin composition according to any one of claims 1 to 6, wherein the resin composition is for filling of a through hole.

8. A magnet sheet comprising:
a support; and
a resin composition layer formed on the support, the resin composition layer **characterized by** being formed of the resin composition according to any one of claims 1 to 7.

9. A circuit substrate comprising:
a substrate having a through hole; and
**characterized by** comprising a cured product of the resin composition according to any one of claims 1 to 7, the cured product being filled in the through hole.

10. A circuit substrate **characterised by** comprising a magnetic layer that is a cured product of the resin composition according to any one of claims 1 to 7.

11. An inductor substrate **characterized by** comprising the circuit substrate according to claim 9 or 10.

## Patentansprüche

1. Harzzusammensetzung, die Folgendes umfasst:
(A) einen Ferrit; und
(B) ein duroplastisches Harz,
wobei der Gehalt der Komponente (A) 70 Massen-% oder mehr und 98 Massen-% oder weniger, bezogen auf 100 Massen-% der nichtflüchtigen Komponenten in der Harzzusammensetzung, beträgt und
der Gehalt der Komponente (B) 1 Massen-% oder mehr und 30 Massen-% oder weniger, bezogen auf 100 Massen-% der nichtflüchtigen Komponenten in der Harzzusammensetzung, beträgt; und
wobei das Harz **dadurch gekennzeichnet ist, dass**:
die Kohlenstoffmenge, die in der Komponente (A) enthalten ist, 0,1 Massen-% oder weniger, bezogen auf 100 Massen-% der Komponente (A), beträgt, wobei
die Kohlenstoffmenge, die in der Komponente (A) enthalten ist, unter Verwendung eines Kohlenstoff-Analysators gemessen wird, im Kohlenstoff-Analysator der zu messende Ferrit mittels eines Hochfrequenz-Induktionsofens verbrannt wird und dann die Kohlenstoffmenge darin durch Messen der Menge an so erzeugtem Kohlenmonoxid und Kohlendioxid mittels eines Infrarotlicht-Absorptionsverfahrens erhalten werden kann, wobei im Kohlenstoff-Analysator der Sauerstoff-Gasdruck auf 2,5 kg/cm² und der Stickstoff-Gasdruck auf 2,8 kg/cm² eingestellt werden, zuerst die Kohlenstoffmenge in einer Standardprobe, deren Kohlenstoffmenge bekannt ist und auf etwa dem gleichen Niveau liegt wie jene des zu messenden Ferrits, gemessen wird, als Nächstes ein Blindversuch ohne Verwendung von Ferrit durchgeführt wird, dann ein Umrechnungs-Koeffizient berechnet wird, als Nächstes der zu messende Ferrit unter Verwendung des Kohlenstoff-Analysators gemessen wird und die Kohlenstoffmenge darin berechnet wird, wobei, wenn die Komponente (A) mit einem Oberflächen-Behandlungsmittel oberflächenmodifiziert ist, der zu messende Ferrit in einem Elektroofen mit bei einer Strömungsrate von 100 ml/min strömendem Stickstoff 6 h lang auf 500 °C erhitzt wird, um das Oberflächen-Behandlungsmittel auf der Ferritoberfläche vor der Messung der Kohlenstoffmenge zu entfernen;
wobei die relative Permeabilität (10 MHz) eines gehärteten Produkts, das durch Heißhärtung der Harzzusammensetzung bei 180 °C über 90 min erhältlich ist wird, 8 oder mehr beträgt und
die maximale Punktfestigkeit (23 °C) eines gehärteten Produkts, das durch Heißhärtung der Harzzusammensetzung bei 190 °C über 90 min erhältlich ist, 40 MPa oder mehr beträgt.

2. Harzzusammensetzung nach Anspruch 1, wobei die Komponente (A) ein kugelförmiger Ferrit ist.

3. Harzzusammensetzung nach Anspruch 2, wobei das Seitenverhältnis des kugelförmigen Ferrits 2 oder weniger beträgt.

4. Harzzusammensetzung nach einem der Ansprüche 1 bis 3, wobei die Komponente (A) zumindest ein Element, ausgewählt aus Ni, Cu, Mn und Zn umfasst.

5. Harzzusammensetzung nach einem der Ansprüche 1 bis 4, wobei die Komponente (B) ein Epoxidharz umfasst.

6. Harzzusammensetzung nach einem der Ansprüche 1 bis 5, wobei die Harzzusammensetzung in pastöser Form vorliegt.

7. Harzzusammensetzung nach einem der Ansprüche 1 bis 6, wobei die Harzzusammensetzung zum Füllen einer Durchgangsbohrung dient.

8. Magnetfolie, die Folgendes umfasst:
einen Träger; und
eine Harzzusammensetzungsschicht, die auf dem Träger ausgebildet ist, wobei die Harzzusammensetzungsschicht **dadurch gekennzeichnet ist, dass** sie aus einer Harzzusammensetzung nach einem der Ansprüche 1 bis 7 geformt ist.

9. Schaltungssubstrat, das Folgendes umfasst:
ein Substrat mit einer Durchgangsbohrung; und
das **dadurch gekennzeichnet ist, dass** es ein gehärtetes Produkt aus einer Harzzusammensetzung nach einem der Ansprüche 1 bis 7 umfasst, wobei das gehärtete Produkt in die Durchgangsbohrung gefüllt ist.

10. Schaltungssubstrat, das **dadurch gekennzeichnet ist, dass** es eine magnetische Schicht umfasst, die ein gehärtetes Produkt aus einer Harzzusammensetzung nach einem der Ansprüche 1 bis 7 ist.

11. Induktorsubstrat, das **dadurch gekennzeichnet ist, dass** es ein Schaltungssubstrat nach Anspruch 9 oder 10 umfasst.

## Revendications

1. Composition de résine, comprenant :
(A) une ferrite ; et
(B) une résine thermodurcissable,
dans laquelle la teneur du composant (A) est de 70 % en masse ou plus et de 98 % en masse ou moins, sur la base de 100 % en masse en tant que composants non volatils dans la composition de résine, et la teneur du composant (B) est de 1 % en masse ou plus et de 30 % en masse ou moins, sur la base de 100 % en masse en tant que composants non volatils dans la composition de résine, et
dans laquelle la résine est **caractérisée en ce que** :
une quantité de carbone incluse dans le composant (A) est de 0,1 % en masse ou moins par rapport à 100 % en masse du composant (A), dans laquelle
la quantité de carbone incluse dans le composant (A) est mesurée en utilisant un analyseur de carbone ; dans l'analyseur de carbone, une ferrite à mesurer est brûlée par un four à induction haute fréquence, puis la quantité de carbone en son sein peut être obtenue en mesurant les quantités de monoxyde de carbone et de dioxyde de carbone ainsi produites par un procédé d'absorption de lumière infrarouge ; dans l'analyseur de carbone, une pression d'oxygène gazeux est établie à 2,5 kg/cm² et une pression d'azote gazeux est établie à 2,8 kg/cm² ; premièrement, la quantité de carbone dans un échantillon standard, dont la quantité de carbone est connue et presque au même niveau que celle de la ferrite à mesurer, est mesurée ; ensuite, un essai à blanc est effectué sans utiliser la ferrite ; puis, un coefficient de conversion est calculé ; ensuite, la ferrite à mesurer est mesurée en utilisant l'analyseur de carbone, et la quantité de carbone en son sein est calculée ; lorsque le composant (A) est modifié en surface avec un agent de traitement de surface, la ferrite à mesurer est chauffée à 500°C pendant 6 heures dans un four électrique avec écoulement d'azote au débit de 100 mL/minute pour éliminer l'agent de traitement de surface sur la surface de ferrite avant la mesure de la quantité de carbone,
une perméabilité relative (10 MHz) d'un produit durci pouvant être obtenu par durcissement thermique de la composition de résine à 180°C pendant 90 minutes est de 8 ou plus, et
une résistance maximale au point (23 °C) d'un produit durci pouvant être obtenu par durcissement thermique de la composition de résine à 190 °C pendant 90 minutes est de 40 MPa ou plus.

2. Composition de résine selon la revendication 1, dans laquelle le composant (A) est une ferrite sphérique.

3. Composition de résine selon la revendication 2, dans laquelle un rapport d'aspect de la ferrite sphérique est de 2 ou moins.

4. Composition de résine selon l'une quelconque des revendications 1 à 3, dans laquelle le composant (A) inclut au moins un élément choisi parmi Ni, Cu, Mn et Zn.

5. Composition de résine selon l'une quelconque des revendications 1 à 4, dans laquelle le composant (B) comprend une résine époxy.

6. Composition de résine selon l'une quelconque des revendications 1 à 5, dans laquelle la composition de résine est sous une forme analogue à une pâte.

7. Composition de résine selon l'une quelconque des revendications 1 à 6, dans laquelle la composition de résine est destinée au remplissage d'un trou traversant.

8. Feuille magnétique, comprenant :
un support ; et
une couche de composition de résine formée sur le support, la couche de composition de résine étant **caractérisée en ce qu'**elle est formée de la composition de résine selon l'une quelconque des revendications 1 à 7.

9. Substrat de circuit, comprenant :
un substrat présentant un trou traversant ; et
**caractérisé en ce qu'**il comprend un produit durci de la composition de résine selon l'une quelconque des revendications 1 à 7, le produit durci étant versé dans le trou traversant.

10. Substrat de circuit **caractérisé en ce qu'**il comprend une couche magnétique qui est un produit durci de la composition de résine selon l'une quelconque des revendications 1 à 7.

11. Substrat d'inductance **caractérisé en ce qu'**il comprend le substrat de circuit selon la revendication 9 ou 10.
